(19) Europäisches Patentamt
European Patent Office
Office européen des brevets

(11) **EP 3 069 359 B1**

(12) **EUROPÄISCHE PATENTSCHRIFT**

(45) Veröffentlichungstag und Bekanntmachung des Hinweises auf die Patenterteilung:
**22.01.2020   Patentblatt 2020/04**

(51) Int Cl.:
*G01R 15/16* *(2006.01)*          *H01G 4/35* *(2006.01)*
*G01R 15/06* *(2006.01)*

(21) Anmeldenummer: **14796499.3**

(22) Anmeldetag: **11.11.2014**

(86) Internationale Anmeldenummer:
**PCT/EP2014/074254**

(87) Internationale Veröffentlichungsnummer:
**WO 2015/071253 (21.05.2015 Gazette 2015/20)**

(54) **VERFAHREN UND VORRICHTUNG ZUR ÜBERWACHUNG VON KONDENSATORDURCHFÜHRUNGEN FÜR EIN DREIPHASIGES WECHSELSTROMNETZ**

METHOD AND APPARATUS FOR MONITORING CAPACITOR BUSHINGS FOR A THREE-PHASE AC SYSTEM

PROCÉDÉ ET DISPOSITIF DE SURVEILLANCE DE CONDENSATEURS DE TRAVERSÉE POUR RÉSEAU DE COURANT ALTERNATIF TRIPHASÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.11.2013   DE 102013112584**

(43) Veröffentlichungstag der Anmeldung:
**21.09.2016   Patentblatt 2016/38**

(73) Patentinhaber: **Maschinenfabrik Reinhausen GmbH**
**93059 Regensburg (DE)**

(72) Erfinder:
• **WU, Junliang**
  **93059 Regensburg (DE)**
• **VIERECK, Karsten**
  **93049 Regensburg (DE)**
• **SUNDERMANN, Ulrich**
  **44149 Dortmund (DE)**

(56) Entgegenhaltungen:
**EP-A1- 0 337 265     EP-A2- 1 039 304**
**DE-C1- 19 519 230**

EP 3 069 359 B1

**Beschreibung**

Die Erfindung betrifft ein Verfahren und eine Vorrichtung zur Überwachung von Kondensatordurchführungen für ein dreiphasiges Wechselstromnetz.

DE 195 19 230 C1 beschreibt ein Überwachungsverfahren und eine Überwachungsanordnung für eine Kondensatordurchführung für hohe Spannungen, die zwischen ihren Kondensatoreinlagen einen Abgriff für eine Teilspannung aufweist. Bei diesem bekannten Verfahren ist vorgesehen, dass die Teilspannung einer Erfassungseinrichtung zugeführt wird, welche die Teilspannung auf eine Änderung überwacht, dass eine Änderungen der Teilspannung und eine Zeitinformation hierzu gespeichert werden, dass der zeitliche Abstand zwischen zumindest zwei Änderungen ermittelt wird, und dass ein der Häufigkeit der Teilspannungsänderung entsprechendes Fehlersignal erzeugt wird. Diese bekannte Vorrichtung umfasst eine Erfassungseinrichtung, in der die Teilspannung auf eine Änderung überwacht wird, einen Speicher, in dem eine Änderungen der Teilspannung und eine Zeitinformation hierzu hinterlegt werden, ein Rechenglied, mit dem der zeitliche Abstand zwischen zumindest zwei Änderungen ermittelt wird, und Mittel zum Erzeugen eines Fehlersignals, wobei ein der Häufigkeit der Teilspannungsänderung proportionales Fehlersignal erzeugt wird. Der Abgriff ist über eine Messdurchführung mittels einer Messleitung an die Erfassungseinrichtung geführt. Der Abgriff liefert eine Teilspannung, die ein Abbild der am Inneren der Kondensatordurchführung anliegenden Hochspannung entspricht.

Da sich die an der Kondensatordurchführung anliegende Hochspannung auf die Messsignale auswirkt und stark schwanken kann, können die am Abgriff erfassten Messwerte stark schwanken. Somit ist eine zuverlässige Überwachung der Kondensatordurchführung nicht gewährleistet.

DE 100 37 432 A1 beschreibt ein Verfahren und eine Vorrichtung zur Überwachung einer mit einer elektrischen Betriebsspannung beaufschlagten Kondensatordurchführung, bei der durch eine elektrisch leitende Einlage ein Spannungsteiler gebildet ist. Bei diesem bekannten Verfahren ist vorgesehen, dass mit einem mit der Einlage verbundenen Messabgriff und mit Erdpotential mindestens ein Messwert einer elektrischen Messgröße erfasst und gespeichert wird, wobei nach Erfassung des mindestens einen Messwerts die Impedanz zwischen dem Messabgriff und dem Erdpotential verändert wird und mit dem Messabgriff und dem Erdpotential mindestens ein Signalwert eines sich dann bildenden Messsignals erfasst und gespeichert wird, wobei der zeitliche Abstand zwischen dem Zeitpunkt der Erfassung des einen Messwerts und dem Zeitpunkt der Erfassung des einen Signalwerts derart bemessen ist, dass mögliche Änderungen der Betriebsspannung zwischen den beiden Zeitpunkten vernachlässigbar sind, wobei anhand des Messwerts und des Signalwerts durch Quotientenbildung eine Kenngröße ermittelt wird, die mit einem vorgegebenen Sollwert verglichen wird, und wobei bei einem Abweichen der Kenngröße von dem vorgegebenen Sollwert ein einen Fehler der Kondensatordurchführung anzeigendes Meldesignal gebildet wird. Bei dieser bekannten Vorrichtung ist ein mit der Einlage verbundener Messabgriff vorgesehen, der mit einer Messeinrichtung zur Erfassung einer elektrischen Messgröße verbunden ist, wobei die zwischen dem Messabgriff und Erdpotential vorliegende Impedanz eine Impedanzanordnung enthält, der eine Schalteinrichtung zugeordnet ist. Die Impedanzanordnung weist eine Fest-Impedanz auf, die über eine Schalteinrichtung an den Messabgriff anschließbar und von dem Messabgriff trennbar ist. Die Schalteinrichtung ist mit einer Steuereinrichtung verbunden. Zur Überwachung der Kondensatordurchführung befindet sich die Impedanzanordnung zunächst in einem ersten Messzustand, bei dem die Schalteinrichtung geöffnet und die Fest-Impedanz nicht mit dem Messabgriff verbunden ist. In diesem ersten Messzustand wird zu einem ersten Zeitpunkt ein Messwert einer elektrischen Messgröße erfasst und in einem Speicher in der Messeinrichtung gespeichert. Diese Messgröße ist hier die am Messabgriff gegen Erdpotential anliegende elektrische Spannung. In diesem Messzustand der Impedanzanordnung wird die Impedanz durch die Parallelschaltung von der Kapazität und dem Innenwiderstand des Messgeräts gebildet. Die Impedanz in diesem Messzustand wird als unveränderte Impedanz bezeichnet. Nach Erfassung der Messgröße wird die Impedanzanordnung in einen zweiten Messzustand versetzt. Dazu wird die Steuereinrichtung durch die Schalteinrichtung gesteuert in den geschlossenen Zustand versetzt. Dadurch ist die Fest-Impedanz jetzt elektrisch leitend mit dem Messabgriff verbunden. Die Impedanz wird nun aus der Parallelschaltung der Kapazität, des Innenwiderstands der Messeinrichtung und der Fest-Impedanz gebildet. In diesem zweiten Messzustand wird nun zu einem zweiten Zeitpunkt mit der Messeinrichtung ein Signalwert eines sich bildenden Messsignals erfasst und ebenfalls gespeichert. Das Messsignal ist die am Messabgriff gegen Erdpotential anliegende elektrische Spannung. Die Impedanz in diesem zweiten Messzustand wird als veränderte Impedanz bezeichnet.

Da sich die an der Kondensatordurchführung anliegende Betriebsspannung auf die Messsignale auswirkt und stark schwanken kann, können die am Messabgriff erfassten Messwerte stark schwanken. Somit ist eine zuverlässige Überwachung der Kondensatordurchführung nicht gewährleistet.

DE 36 01 934 C2 beschreibt eine permanent überwachte Kondensatordurchführungsanordnung bei Großtransformatoren in Drehstromnetzen, mit drei Kondensatordurchführungen, von denen jede aus einem Wickelkörper mit eingebetteten Kondensatorbelägen besteht, mit je einem Messanschluss, der mit dem letzten äußeren Kondensatorbelag verbunden ist, und mit einer äußeren Flanschkapazität zwischen dem letzten äußeren Kondensatorbelag und dem geerdeten Flansch einer jeden Durchführung, Bei dieser bekannten Kondensatordurchführungsanordnung ist vorgesehen, dass die Messanschlüsse der drei Kondensatordurchführungen über je einen Abgleichkondensator zu einem künstlichen Sternpunkt verbunden sind, der auf Erdpotential einstellbar ist, wobei zwischen dem künstlichen Sternpunkt und dem Erdpotential eine Messeinrichtung angeordnet ist. Es ist vorgesehen, dass die Messeinrichtung mit einer Auslöseeinrichtung verbunden ist, die bei einer Kapazitätsänderung der Kondensatorbeläge die gesamte Anordnung abschaltet.

US 4 757 263 A beschreibt, dass zur Überwachung der Isoliereigenschaften von Hochspannungsdurchführungen Kapazitätswerte bestimmt werden.

Es ist Aufgabe der Erfindung, ein Verfahren und eine Vorrichtung zur Überwachung von Kondensatordurchführungen für ein dreiphasiges Wechselstromnetz zu schaffen, die eine bessere Überwachung ermöglichen.

Diese Aufgabe wird gelöst durch die Gegenstände der unabhängigen Ansprüche. Vorteilhafte Weiterbildungen sind in den Unteransprüchen beschrieben.

Die Erfindung schlägt gemäß einem ersten Aspekt ein Verfahren zur Überwachung von Kondensatordurchführungen für ein dreiphasiges Wechselstromnetz vor, wobei jede Kondensatordurchführung einen Leiter, der mit einer der Netzleitungen des Wechselstromnetzes verbunden ist, und einen elektrisch leitfähigen Belag aufweist, der den Leiter umgibt, mit den Schritten, dass

- für jede Kondensatordurchführung eine Oberkapazität $C_{0a}$, $C_{0b}$, $C_{0c}$ und eine Unterkapazität $C_{1a}$, $C_{1b}$, $C_{1c}$ ermittelt werden;
- an jeder Kondensatordurchführung eine Messspannung $U_{1a}$, $U_{1b}$, $U_{1c}$ erfasst und/oder gemessen wird, die zwischen dem jeweiligen Belag und einem Massepotenzial anliegt;
- für jede Kondensatordurchführung eine Istkapazität $C_{0a}'$, $C_{0b}'$, $C_{0c}'$ berechnet wird, die von der jeweiligen Messspannung, der jeweiligen Unterkapazität sowie von der Messspannung, der Unterkapazität und der Oberkapazität einer der anderen Kondensatordurchführungen abhängt;
- für jede Kondensatordurchführung die jeweilige Oberkapazität mit der jeweiligen Istkapazität verglichen wird;
- ein Überwachungssignal erzeugt wird, das von den Ergebnissen der Kapazitätsvergleiche abhängt.

Bei dem vorgeschlagenen Verfahren werden die Oberkapazitäten der Kondensatordurchführungen sowie deren Istkapazitäten im Betrieb miteinander verglichen, was hier auch als Kapazitätsvergleiche bezeichnet wird. Sollte sich eine Istkapazität verändern, kann auf eine Beschädigung der entsprechenden Kondensatordurchführung geschlossen werden.

Das vorgeschlagene Verfahren nutzt die Kenn- und Messgrößen anderer Kondensatordurchführungen für die eigentliche Überwachung. Hierbei werden die Messspannungen, Unterkapazitäten, Oberkapazitäten sowie Istkapazitäten einer Kondensatordurchführung sowie einer der anderen Kondensatordurchführungen verwendet. Damit wird erreicht, dass beim Überwachen einer Kondensatordurchführung, die ja an die ihr zugeordnete Netzleitung angeschlossen ist, Schwankungen der an einer Netzleitung anliegenden Netzspannung, die über die an die jeweilige Netzleitung angeschlossene Kondensatordurchführung auf die Messspannung übertragen werden, sowie Messtoleranzen beim Erfassen der Messspannung zumindest teilweise kompensiert werden können und eine bessere Aussage über den Zustand der Kondensatordurchführung getroffen werden kann.

Die Oberkapazität für jede Kondensatordurchführung kann nach Bedarf auf beliebige Art und Weise definiert sein, beispielsweise als die Kapazität eines Kondensators, der von dem jeweiligen Belag und dem jeweiligen Leiter gebildet wird und hier als Oberspannungskondensator bezeichnet wird. Üblicherweise liegen die Oberkapazitäten zwischen 300 und 600 pF.

Jede Kondensatordurchführung kann nach Bedarf auf beliebige Art und Weise ausgebildet sein und beispielsweise wenigstens einen zusätzlichen Belag aufweisen, der insbesondere zwischen dem einen Belag und dem Leiter angeordnet ist, so dass dieser eine Belag einen äußersten Belag darstellt. Dann kann die Oberkapazität beispielsweise auch als die Kapazität einer Reihenschaltung definiert sein, die Kondensatoren, die jeweils von zwei benachbarten Belägen gebildet werden, sowie einen Kondensator, der von dem innersten der zusätzlichen Beläge und dem Leiter gebildet wird, aufweist und hier ebenfalls als Oberspannungskondensator bezeichnet wird.

Die Unterkapazität für jede Kondensatordurchführung kann nach Bedarf auf beliebige Art und Weise definiert sein, beispielsweise als die Kapazität einer Parallelschaltung, die eine Messeinrichtung, mit der beispielsweise die jeweilige Messspannung erfasst und/oder gemessen werden kann, und einen Kondensator, der von dem jeweiligen äußersten Belag und Massepotenzial oder von dem jeweiligen äußersten Belag und einem elektrisch leitfähigen Flansch, der an der Außenfläche der jeweiligen Kondensatordurchführung befestigt ist und an Massepotenzial anliegt, gebildet wird und hier als Außenkondensator bezeichnet wird, aufweist und hier als Unterspannungskondensator bezeichnet wird. Üblicherweise liegen die Unterkapazitäten zwischen 1 und 5 $\mu$F, sie können aber auch nach Bedarf andere Werte haben und beispielsweise zwischen 0,1 $\mu$F und 50 $\mu$F oder zwischen 0,2 $\mu$F und 20 $\mu$F oder zwischen 0,5 $\mu$F und 10 $\mu$F liegen. Alternativ oder zusätzlich können jede dieser Unterkapazitäten und wenigstens eine der anderen Unterkapazitäten gleich oder ungleich sein. Beispielsweise können die Unterkapazitäten im Verhältnis 1:2:3 oder 1:2:4 oder 1:2:5 oder 1:3:5 oder 1:3:7 oder 1:3:9 oder 1:4:7 oder 1:4:9 zueinander stehen.

Das Überwachungssignal kann nach Bedarf auf beliebige Art und Weise ausgebildet sein, beispielsweise als akustisches und/oder optisches und/oder elektronisches Signal.

Das Ermitteln der Oberkapazität für eine Kondensatordurchführung kann nach Bedarf auf beliebige Art und Weise erfolgen, beispielsweise durch Messen, vorzugsweise an einer unbeschädigten oder fehlerfreien Kondensatordurchführung, oder durch Entnahme aus einem Datenblatt der Kondensatordurchführung oder durch Setzen auf einen Erfahrungswert oder durch Übernahme von einem früheren Durchlauf des Verfahrens. Alternativ oder zusätzlich kann das Ermitteln wenigstens einer Oberkapazität beispielsweise vor oder nach oder gleichzeitig mit dem Ermitteln wenigstens einer der anderen Oberkapazitäten und/oder vor oder nach oder gleichzeitig mit dem Ermitteln wenigstens einer Unterkapazität und/oder vor oder nach oder gleichzeitig mit dem Erfassen wenigstens einer Messspannung erfolgen.

Das Ermitteln der Unterkapazität für eine Kondensatordurchführung kann nach Bedarf auf beliebige Art und Weise erfolgen, beispielsweise durch Messen, vorzugsweise an einer unbeschädigten oder fehlerfreien Kondensatordurchführung, oder durch Entnahme aus einem Datenblatt der Kondensatordurchführung oder durch Setzen auf einen Erfahrungswert oder durch Übernahme von einem früheren Durchlauf des Verfahrens. Alternativ oder zusätzlich kann das Ermitteln wenigstens einer Unterkapazität beispielsweise vor oder nach oder gleichzeitig mit dem Ermitteln wenigstens einer der anderen Unterkapazitäten und/oder vor oder nach oder gleichzeitig mit dem Ermitteln wenigstens einer Oberkapazität und/oder vor oder nach oder gleichzeitig mit dem Erfassen wenigstens einer Messspannung erfolgen.

Das Erfassen wenigstens einer Messspannung kann nach Bedarf auf beliebige Art und Weise erfolgen, beispielsweise vor oder nach oder bevorzugt gleichzeitig mit dem Erfassen wenigstens einer der anderen Messspannungen und/oder vor oder nach oder gleichzeitig mit dem Ermitteln wenigstens einer Oberkapazität und/oder vor oder nach oder gleichzeitig mit dem Ermitteln wenigstens einer Unterkapazität.

Es kann vorgesehen sein, dass

- für jede Phase die Netzspannung Ua, Ub, Uc erfasst und/oder gemessen wird;
- die Netzspannungen untereinander verglichen werden;
- falls der Spannungsvergleich ergibt, dass die Netzspannungen nicht mehr als ein vorbestimmtes Maß voneinander abweichen, dann das Berechnen der Istkapazitäten, das Vergleichen der Kapazitäten und das Erzeugen des Überwachungssignals erfolgt.

Dieses Vergleichen der Netzspannungen, was hier auch als Spannungsvergleich bezeichnet wird, ermöglicht, dass ein Zeitpunkt bestimmt wird, zu dem die eigentliche Überwachung, nämlich das Berechnen der Istkapazitäten, die Kapazitätsvergleiche und das Erzeugen des Überwachungssignals, besonders vorteilhaft oder günstig ist, da sie dann nicht durch über das vorbestimmte Maß hinaus voneinander abweichende Netzspannungen erschwert, behindert oder gar unmöglich gemacht wird. Damit wird erreicht, dass unabhängig von Schwankungen der Netzspannungen sowie von Messtoleranzen beim Erfassen der Messspannungen eine bessere Aussage über den Zustand der Kondensatordurchführungen getroffen werden kann.

Durch die Berücksichtigung der Netzspannungen können beispielsweise zeitliche Änderungen der Spannungsverhältnisse, die auch als Asymmetrien bezeichnet werden, erfasst werden und somit die entsprechenden Abweichungen der an den Kondensatordurchführungen abgegriffenen Messspannungen zumindest teilweise kompensiert werden. Damit wird eine zuverlässige Überwachung der Kondensatordurchführungen unter Berücksichtigung und Bewertung der Abweichungen und der Störungen der Netzspannungen gewährleistet.

Das Erfassen wenigstens einer Netzspannung kann nach Bedarf auf beliebige Art und Weise erfolgen, beispielsweise vor oder nach oder bevorzugt gleichzeitig mit dem Erfassen wenigstens einer der anderen Netzspannungen und/oder nach oder gleichzeitig mit oder bevorzugt vor dem Ermitteln wenigstens einer Oberkapazität und/oder nach oder gleichzeitig mit oder bevorzugt vor dem Ermitteln wenigstens einer Unterkapazität und/oder nach oder gleichzeitig mit oder bevorzugt vor dem Erfassen wenigstens einer Messspannung.

Der Spannungsvergleich kann nach Bedarf auf beliebige Art und Weise erfolgen, beispielsweise nach oder gleichzeitig mit oder bevorzugt vor dem Ermitteln wenigstens einer Oberkapazität und/oder nach oder gleichzeitig mit oder bevorzugt vor dem Ermitteln wenigstens einer Unterkapazität und/oder nach oder gleichzeitig mit oder bevorzugt vor dem Erfassen wenigstens einer Messspannung. Falls der Spannungsvergleich ergibt, dass die Netzspannungen nicht mehr als ein vorbestimmtes Maß voneinander abweichen, dann erfolgt vorzugsweise das Ermitteln der Oberkapazitäten und/oder das Ermitteln der Unterkapazitäten und/oder das Erfassen der Messspannungen und schließlich das Berechnen der Istkapazitäten, das Vergleichen der Kapazitäten und das Erzeugen des Überwachungssignals.

Falls der Spannungsvergleich ergibt, dass die Netzspannungen mehr als ein vorbestimmtes Maß voneinander abweichen, dann erfolgt nicht das Berechnen der Istkapazitäten, das Vergleichen der Kapazitäten und das Erzeugen des Überwachungssignals, sondern ein neuer Durchlauf des Verfahrens. Dann erfolgt vorzugsweise auch nicht das Ermitteln der Oberkapazitäten und/oder das Ermitteln der Unterkapazitäten und/oder das Erfassen der Messspannungen.

Nach dem Erzeugen des Überwachungssignals erfolgt vorzugsweise ein neuer oder nächster oder weiterer Durchlauf des Verfahrens.

Es kann vorgesehen sein, dass

- beim Spannungsvergleich Effektivwerte Uae, Ube, Uce und/oder Scheitelwerte und/oder Amplituden der Netzspannungen Ua, Ub, Uc ermittelt und/oder verwendet werden.

Es kann vorgesehen sein, dass

- Toleranzwerte UAB > 0, UBC > 0, UCA > 0 für den Spannungsvergleich bestimmt werden;
- der Spannungsvergleich derart erfolgt, dass geprüft wird, ob

$$|Uae - Ube| \leq UAB \text{ und } |Ube - Uce| \leq UBC \text{ und } |Uce - Uae| \leq UCA$$

gilt.

Jeder dieser Toleranzwerte UAB, UBC, UCA kann nach Bedarf auf beliebige Art und Weise bestimmt werden und beispielsweise auf einen Wert gesetzt werden, der 0,1% oder 0,2% oder 0,5% oder 1% oder 2% oder 3% oder 4% oder 5% oder 7% oder 10% oder 15% oder 20% oder 25% oder 30% oder 40% oder 50% des Nennwertes der jeweiligen Netzspannung Uae, Ube, Uce entspricht. Jeder dieser Toleranzwerte und wenigstens einer der anderen Toleranzwerte können gleich oder ungleich sein.
Es kann vorgesehen sein, dass

- die Istkapazität der ersten Kondensatordurchführung gemäß folgender Formel berechnet wird:

$$C_{0a}{'} = C_{1a} \times \frac{U_{1a} \times K_a}{\dfrac{U_{1b} \times C_{1b}}{C_{0b}} + U_{1b} - U_{1a} \times K_a}$$

worin Ka ein Korrekturwert ist, für den Ka = 1 oder Ka = Ub/Ua oder Ka = Ube/Uae gilt; und/oder
- die Istkapazität der zweiten Kondensatordurchführung gemäß folgender Formel berechnet wird:

$$C_{0b}{'} = C_{1b} \times \frac{U_{1b} \times K_b}{\dfrac{U_{1c} \times C_{1c}}{C_{0c}} + U_{1c} - U_{1b} \times K_b}$$

worin Kb ein Korrekturwert ist, für den Kb = 1 oder Kb = Uc/Ub oder Kb = Uce/Ube gilt; und/oder
- die Istkapazität der dritten Kondensatordurchführung gemäß folgender Formel berechnet wird:

$$C_{0c}{'} = C_{1c} \times \frac{U_{1c} \times Kc}{\dfrac{U_{1a} \times C_{1a}}{C_{0a}} + U_{1a} - U_{1c} \times Kc}$$

worin Kc ein Korrekturwert ist, für den Kc = 1 oder Kc = Ua/Uc oder Kc = Uae/Uce gilt.
Ein Korrekturwert, für den die zweite Alternative, also der Quotient aus zwei Netzspannungen gilt, ergibt oder ermöglicht eine automatische Korrektur und/oder automatische Kompensation von Asymmetrien und/oder Abweichungen zwischen diesen beiden Netzspannungen. Hierdurch kann eine noch genauere Bestimmung der entsprechenden Istkapazität erreicht werden.
Jeder dieser Korrekturwerte kann nach Bedarf beliebig gewählt sein. Falls für die Korrekturwerte beispielsweise jeweils die erste Alternative, also Ka = Kb = Kc = 1 gewählt wird, dann sollte vorzugsweise der Spannungsvergleich vor der eigentlichen Überwachung verwendet werden und dabei weiter bevorzugt jeder der Toleranzwerte UAB, UBC, UCA auf einen eher niedrigen Wert gesetzt werden sollte, der beispielsweise 0,1% oder 0,2% oder 0,5% oder 1% oder 2% oder 3% oder 4% oder 5% oder 7% oder 10% des Nennwertes der jeweiligen Netzspannung Uae, Ube, Uce entspricht. Falls für die Korrekturwerte beispielsweise jeweils die zweite Alternative, also Ka = Ub/Ua und Kb = Uc/Ub und Kc = Ua/Uc gewählt wird, dann kann nach Bedarf auf den Spannungsvergleich vor der eigentlichen Überwachung verzichtet werden oder der Spannungsvergleich vor der eigentlichen Überwachung erfolgen und dabei vorzugsweise jeder der Toleranzwerte UAB, UBC, UCA auf einen eher höheren Wert gesetzt werden, der beispielsweise 2% oder 3% oder 4% oder 5% oder 7% oder 10% oder 15% oder 20% oder 25% oder 30% oder 40% oder 50% des Nennwertes der jeweiligen Netzspannung Uae, Ube, Uce entspricht.

Das Berechnen wenigstens einer Istkapazität kann nach Bedarf auf beliebige Art und Weise erfolgen, beispielsweise vor oder nach oder gleichzeitig mit dem Berechnen wenigstens einer der anderen Istkapazitäten.

Es kann vorgesehen sein, dass

- Toleranzwerte CA > 0, CB > 0, CC > 0 für die Kapazitätsvergleiche bestimmt werden;
- falls die Kapazitätsvergleiche ergeben, dass

$$|C0a' - C0a| \leq CA \text{ und } |C0b' - C0b| \leq CB \text{ und } |C0c' - C0c| \leq CC$$

gilt, dann ein Überwachungssignal erzeugt wird, das anzeigt, dass die Kondensatordurchführungen in ordnungsgemäßem Zustand sind.

Somit werden nach dem Bestimmen der Toleranzwerte die Kapazitätsvergleiche in einem Prüfschritt ausgewertet, was hier auch als erstes Auswerten oder erste Auswertung bezeichnet wird, und ein von dem Ergebnis dieser ersten Auswertung abhängiges Überwachungssignal erzeugt.

Jeder dieser Toleranzwerte CA, CB, CC kann nach Bedarf auf beliebige Art und Weise bestimmt werden und beispielsweise auf einen Wert gesetzt werden, der 0,001% oder 0,002% oder 0,003% oder 0,004% oder 0,005% oder 0,007% oder 0,01% oder 0,012% oder 0,015% oder 0,02% der jeweiligen Oberkapazität C0a, C0b, C0c oder eines Mittelwerts der Oberkapazitäten C0a, C0b, C0c entspricht. Dieser Mittelwert kann nach Bedarf beliebig gewählt sein, beispielsweise als das arithmetische Mittel oder das geometrische Mittel oder das harmonische Mittel oder das quadratische Mittel. Jeder dieser Toleranzwerte und wenigstens einer der anderen Toleranzwerte können gleich oder ungleich sein.

Es kann vorgesehen sein, dass

- andernfalls ein Überwachungssignal erzeugt wird, das anzeigt, dass zumindest eine Kondensatordurchführung nicht in ordnungsgemäßem Zustand ist.

Somit wird dieses Überwachungssignal erzeugt, falls die erste Auswertung ergibt, dass der geprüfte Fall nicht vorliegt.

Es kann vorgesehen sein, dass

- Toleranzwerte CA > 0, CB > 0, CC > 0 für die Kapazitätsvergleiche bestimmt werden;
- falls die Kapazitätsvergleiche ergeben, dass

$$C0a' - C0a < -CA \text{ und } C0b' - C0b > CB \text{ und } |C0c' - C0c| \leq CC$$

gilt, dann ein Überwachungssignal erzeugt wird, das anzeigt, dass zumindest die zweite Kondensatordurchführung nicht in ordnungsgemäßem Zustand ist;
- falls die Kapazitätsvergleiche ergeben, dass

$$C0b' - C0b < -CB \text{ und } C0c' - C0c > CC \text{ und } |C0a' - C0a| \leq CA$$

gilt, dann ein Überwachungssignal erzeugt wird, das anzeigt, dass zumindest die dritte Kondensatordurchführung nicht in ordnungsgemäßem Zustand ist;
- falls die Kapazitätsvergleiche ergeben, dass

$$C0c' - C0c < -CC \text{ und } C0a' - C0a > CA \text{ und } |C0b' - C0b| \leq CB$$

gilt, dann ein Überwachungssignal erzeugt wird, das anzeigt, dass zumindest die erste Kondensatordurchführung nicht in ordnungsgemäßem Zustand ist.

Somit werden nach dem Bestimmen der Toleranzwerte die Kapazitätsvergleiche in vier Prüfschritten ausgewertet, was hier auch als zweites Auswerten oder zweite Auswertung bezeichnet wird, und ein von dem Ergebnis dieser zweiten Auswertung abhängiges Überwachungssignal erzeugt. Jeder dieser Prüfschritte kann nach Bedarf auf beliebige Art und Weise erfolgen, beispielsweise vor oder nach oder gleichzeitig mit wenigstens einem anderen Prüfschritt.

Jeder dieser Toleranzwerte CA, CB, CC kann nach Bedarf auf beliebige Art und Weise bestimmt werden und beispielsweise auf einen Wert gesetzt werden, der 0,001% oder 0,002% oder 0,003% oder 0,004% oder 0,005% oder 0,007% oder 0,01% oder 0,012% oder 0,015% oder 0,02% der jeweiligen Oberkapazität C0a, C0b, COc oder eines Mittelwerts der Oberkapazitäten C0a, C0b, COc entspricht. Dieser Mittelwert kann nach Bedarf beliebig gewählt sein, beispielsweise als das arithmetische Mittel oder das geometrische Mittel oder das harmonische Mittel oder das quadratische Mittel. Jeder dieser Toleranzwerte und wenigstens einer der anderen Toleranzwerte können gleich oder ungleich sein. Falls schon einmal Toleranzwerte CA, CB, CC bestimmt worden sind, beispielsweise für das erste oder das weiter unten beschriebene dritte Auswerten, so können diese vorzugsweise auch für dieses zweite Auswerten übernommen werden.

Es kann vorgesehen sein, dass

- andernfalls ein Überwachungssignal erzeugt wird, das anzeigt, dass zumindest zwei Kondensatordurchführungen nicht in ordnungsgemäßem Zustand sind.

Somit wird dieses Überwachungssignal erzeugt, falls die zweite Auswertung ergibt, dass die geprüften Fälle nicht vorliegen.

Es kann vorgesehen sein, dass

- Toleranzwerte CA > 0, CB > 0, CC > 0 für die Kapazitätsvergleiche bestimmt werden;
- falls die Kapazitätsvergleiche ergeben, dass

$$C0a' - C0a > CA \text{ und } C0b' - C0b < -CB \text{ und } |C0c' - C0c| \le CC$$

gilt, dann ein Überwachungssignal erzeugt wird, das anzeigt, dass die erste und die dritte Kondensatordurchführung nicht in ordnungsgemäßem Zustand sind und einen gleichartigen Fehler haben;
- falls die Kapazitätsvergleiche ergeben, dass

$$C0b' - C0b > CB \text{ und } C0c' - C0c < -CC \text{ und } |C0a' - C0a| \le CA$$

gilt, dann ein Überwachungssignal erzeugt wird, das anzeigt, dass die zweite und die erste Kondensatordurchführung nicht in ordnungsgemäßem Zustand sind und einen gleichartigen Fehler haben;
- falls die Kapazitätsvergleiche ergeben, dass

$$C0c' - C0c > CC \text{ und } C0a' - C0a < -CA \text{ und } |C0b' - C0b| \le CB$$

gilt, dann ein Überwachungssignal erzeugt wird, das anzeigt, dass die dritte und die zweite Kondensatordurchführung nicht in ordnungsgemäßem Zustand sind und einen gleichartigen Fehler haben.

Somit werden nach dem Bestimmen der Toleranzwerte die Kapazitätsvergleiche in drei Prüfschritten ausgewertet, was hier auch als drittes Auswerten oder dritte Auswertung bezeichnet wird, und ein von dem Ergebnis dieser dritten Auswertung abhängiges Überwachungssignal erzeugt. Jeder dieser Prüfschritte kann nach Bedarf auf beliebige Art und Weise erfolgen, beispielsweise vor oder nach oder gleichzeitig mit wenigstens einem der anderen Prüfschritte.

Jeder dieser Toleranzwerte CA, CB, CC kann nach Bedarf auf beliebige Art und Weise bestimmt werden und beispielsweise auf einen Wert gesetzt werden, der 0,001% oder 0,002% oder 0,003% oder 0,004% oder 0,005% oder 0,007% oder 0,01% oder 0,012% oder 0,015% oder 0,02% der jeweiligen Oberkapazität C0a, C0b, COc oder eines Mittelwerts der Oberkapazitäten C0a, C0b, COc entspricht. Dieser Mittelwert kann nach Bedarf beliebig gewählt sein, beispielsweise als das arithmetische Mittel oder das geometrische Mittel oder das harmonische Mittel oder das quadratische Mittel. Jeder dieser Toleranzwerte und wenigstens einer der anderen Toleranzwerte können gleich oder ungleich sein. Falls schon einmal Toleranzwerte CA, CB, CC bestimmt worden sind, beispielsweise für das erste oder das zweite Auswerten, so können diese vorzugsweise auch für dieses zweite Auswerten übernommen werden.

Die Erfindung schlägt gemäß einem zweiten Aspekt eine Vorrichtung zur Überwachung von Kondensatordurchführungen für ein dreiphasiges Wechselstromnetz vor, wobei jede Kondensatordurchführung einen Leiter, der mit einer der Netzleitungen des Wechselstromnetzes verbunden ist, und einen elektrisch leitfähigen Belag aufweist, der den Leiter umgibt, wobei die Vorrichtung insbesondere zur Durchführung eines der vorgeschlagenen Verfahren ausgebildet und/oder geeignet ist und/oder dient, aufweisend oder umfassend

- eine Messeinrichtung;
- für jede Phase einen Messadapter, der mit dem Belag der zu der jeweiligen Phase gehörenden Kondensatordurchführung verbunden werden kann und mit der Messeinrichtung verbunden ist, um eine erste elektrische Messgröße zu erfassen und/oder zu messen;
- eine Auswerteeinrichtung, die mit der Messeinrichtung verbunden ist, um die ersten Messgrößen an die Auswerteeinrichtung zu übermitteln.

Durch die Zusammenführung der ersten Messgrößen in einer Auswerteeinrichtung ist es möglich, eine zentrale Überwachung einzurichten und damit die Schwankungen der Netzspannungen in allen Strängen des Wechselstromnetzes bei der Überwachung aller Kondensatordurchführungen zu erfassen. Eine zuverlässige Überwachung der Kondensatordurchführungen wird damit gewährleistet.

Diese gemäß dem zweiten Aspekt vorgeschlagene Vorrichtung ermöglicht eine kontinuierliche Überwachung der Kondensatordurchführungen.

Mit der gemäß dem zweiten Aspekt vorgeschlagenen Vorrichtung kann beispielsweise eines der vorgeschlagenen Verfahren durchgeführt werden.

Die gemäß dem zweiten Aspekt vorgeschlagene Vorrichtung kann nach Bedarf auf beliebige Art und Weise ausgebildet sein und beispielsweise wenigstens eine weitere Messeinrichtung und/oder wenigstens einen weiteren Messadapter und/oder wenigstens eine weitere Auswerteeinrichtung aufweisen. Es kann beispielsweise für jeden Messadapter eine eigene Messeinrichtung und/oder eine eigene Auswerteeinrichtung vorgesehen sein. Alternativ kann die Messeinrichtung als gemeinsame Messeinrichtung für wenigstens zwei oder für alle Messadapter ausgebildet sein.

Die Auswerteeinrichtung kann nach Bedarf auf beliebige Art und Weise ausgebildet sein, beispielsweise als gemeinsame Auswerteeinrichtung für wenigstens zwei oder für alle Messeinrichtungen. Alternativ oder zusätzlich kann sie beispielsweise eine Oberauswerteeinrichtung und für jede Phase eine eigene Unterauswerteeinrichtung aufweisen, die mit der zu der jeweiligen Phase gehörenden Messeinrichtung und der Oberauswerteeinrichtung verbunden ist.

Die Netzleitung kann nach Bedarf auf beliebige Art und Weise ausgebildet sein, beispielsweise als Hochspannungsleitung.

Bevorzugt ist die gemäß dem zweiten Aspekt vorgeschlagene Vorrichtung derart ausgebildet, dass sie eines der vorgeschlagenen Verfahren durchführt und/oder durchführen kann.

Es kann vorgesehen sein, dass die gemäß dem zweiten Aspekt vorgeschlagene Vorrichtung zusätzlich aufweist oder umfasst

- für jede Phase einen Spannungswandler, der mit der zu der jeweiligen Phase gehörenden Netzleitung verbunden werden kann, um eine zweite elektrische Messgröße zu erfassen und/oder zu messen, und der mit der Auswerteeinrichtung verbunden ist, um die zweite Messgröße an die Auswerteeinrichtung zu übermitteln.

Durch die Verwendung der zweiten Messgrößen, die mit den Spannungswandlern an den Netzleitungen erfasst werden, können zeitliche Änderungen und/oder Schwankungen der Netzspannungen und/oder von Verhältnissen der Netzspannungen, wie beispielsweise transiente Phänomene oder Asymmetrien, erfasst und/oder erkannt werden und beispielsweise mit den ersten Messgrößen und/oder deren zeitliche Änderungen und/oder Schwankungen verglichen werden. Eine zuverlässige Überwachung der Kondensatordurchführungen unter Berücksichtigung und Bewertung der Änderungen und/oder Schwankungen der Netzspannung wird damit gewährleistet.

Die Auswerteeinrichtung kann nach Bedarf auf beliebige Art und Weise ausgebildet sein, beispielsweise als gemeinsame Auswerteeinrichtung für wenigstens zwei oder für alle Messeinrichtungen und/oder für wenigstens zwei oder für alle Spannungswandler. Alternativ oder zusätzlich kann sie beispielsweise eine Oberauswerteeinrichtung und für jede Phase eine eigene Unterauswerteeinrichtung aufweisen, die mit der zu der jeweiligen Phase gehörenden Messeinrichtung, dem zu der jeweiligen Phase gehörenden Spannungswandler und der Oberauswerteeinrichtung verbunden ist.

Es kann vorgesehen sein, dass

- jeder Spannungswandler als kapazitiver Spannungswandler oder induktiver Spannungswandler oder resistiver Spannungswandler ausgebildet ist.

Jeder Spannungswandler kann nach Bedarf auf beliebige Art und Weise ausgebildet sein und/oder mittels unterschiedlicher geeigneter Prinzipien realisiert werden oder sein. Er kann beispielsweise induktiv und/oder kapazitiv und/oder resistiv aufgebaut sein und/oder induktive und/oder kapazitive und/oder resistive Komponenten und/oder Bauteile aufweisen. Bevorzugt kann er einen kapazitiven Spannungsteiler, der zwei Kondensatoren, die in Reihe geschaltet sind, aufweist, und zwei Spulen oder Wicklungen aufweisen, die als Transformator zur induktiven galvanischen Trennung geschaltet sind.

Es kann vorgesehen sein, dass

- die Messeinrichtung oder wenigstens eine der Messeinrichtungen wenigstens einen Messkondensator aufweist.

Die Kapazität wenigstens eines der Messkondensatoren ist vorzugsweise um ein Vielfaches größer als die Kapazität des jeweiligen Außenkondensators.

Üblicherweise liegen die Kapazitäten der Messkondensatoren zwischen 1 und 5 $\mu$F, sie können aber auch nach Bedarf andere Werte haben und beispielsweise zwischen 0,1 $\mu$F und 50 $\mu$F oder zwischen 0,2 $\mu$F und 20 $\mu$F oder zwischen 0,5 $\mu$F und 10 $\mu$F liegen.

Die Kapazitäten der Messkondensatoren können nach Bedarf auf beliebige Art und Weise gewählt sein. So können beispielsweise für den Fall, dass in jeder Phase ein Messadapter an einen eigenen Messkondensator, der nur ihm zugeordnet ist, angeschlossen ist und diese drei Messkondensatoren in einer gemeinsamen Messeinrichtung zusammengefasst oder auf drei eigene Messeinrichtungen, die den Messadaptern zugeordnet sind, verteilt sind, die Kapazitäten dieser drei Messkondensatoren gleich sein oder zwei dieser Kapazitäten gleich und ungleich der dritten Kapazität sein oder alle drei Kapazitäten ungleich sein. Diese drei Kapazitäten können beispielsweise im Verhältnis 1:2:3 oder 1:2:4 oder 1:2:5 oder 1:3:5 oder 1:3:7 oder 1:3:9 oder 1:4:7 oder 1:4:9 zueinander stehen.

Es kann vorgesehen sein, dass

- die ersten Messgrößen elektrische Spannungen sind, die jeweils an einem Unterspannungskondensator der jeweiligen Phase anliegen.

Jeder Unterspannungskondensator kann nach Bedarf auf beliebige Art und Weise ausgebildet sein und beispielsweise eine Kapazität, die hier als Unterkapazität bezeichnet wird, zwischen 0,1 $\mu$F und 50 $\mu$F oder zwischen 0,2 $\mu$F und 20 $\mu$F oder zwischen 0,5 $\mu$F und 10 $\mu$F oder zwischen 1 und 5 $\mu$F haben. Alternativ oder zusätzlich können jede dieser Unterkapazitäten und wenigstens eine der anderen Unterkapazitäten gleich oder ungleich sein. Beispielsweise können die Unterkapazitäten im Verhältnis 1:2:3 oder 1:2:4 oder 1:2:5 oder 1:3:5 oder 1:3:7 oder 1:3:9 oder 1:4:7 oder 1:4:9 zueinander stehen.

Es kann vorgesehen sein, dass

- die zweiten Messgrößen elektrische Spannungen sind, die jeweils zwischen der jeweiligen Netzleitung und Massepotenzial anliegen.

Diese Spannungen werden hier auch als Netzspannungen bezeichnet.

Es kann vorgesehen sein, dass

- die Auswerteeinrichtung derart ausgebildet ist, dass sie

  • für jede Kondensatordurchführung eine Istkapazität berechnet oder berechnen kann, die von der jeweiligen Messspannung, einer Unterkapazität der jeweiligen Kondensatordurchführung sowie von der Messspannung, einer Unterkapazität und einer Oberkapazität einer der anderen Kondensatordurchführungen abhängt.

Es kann vorgesehen sein, dass

- die Auswerteeinrichtung derart ausgebildet ist, dass sie

  • für jede Kondensatordurchführung die jeweilige Oberkapazität mit der jeweiligen Istkapazität vergleicht oder vergleichen kann.

Die Erfindung schlägt gemäß einem dritten Aspekt eine Vorrichtung zur Überwachung von Kondensatordurchführungen für ein dreiphasiges Wechselstromnetz vor, wobei jede Kondensatordurchführung einen Leiter, der mit einer der Netzleitungen des Wechselstromnetzes verbunden ist, und einen elektrisch leitfähigen Belag aufweist, der den Leiter umgibt, wobei die Vorrichtung insbesondere wie eine der gemäß dem zweiten Aspekt vorgeschlagenen Vorrichtungen ausgebildet ist, aufweisend oder umfassend

- Mittel, die derart ausgebildet und/oder dazu dienen und/oder geeignet sind, dass sie an jeder Kondensatordurchführung eine Messspannung U1a, U1b, U1c erfassen und/oder messen, die zwischen dem jeweiligen Belag und einem Massepotenzial anliegt;
- Mittel, die derart ausgebildet und/oder dazu dienen und/oder geeignet sind, dass sie für jede Kondensatordurchführung eine Istkapazität COa', COb', COc' berechnen, die von der jeweiligen Messspannung U1a, U1b, U1c, einer Unterkapazität C1a, C1b, C1c der jeweiligen Kondensatordurchführung sowie von der Messspannung U1b, U1c, U1a, einer Unterkapazität C1b, C1c, C1a und einer Oberkapazität C0b, C0c, COa einer der beiden anderen Kondensatordurchführungen abhängt;
- Mittel, die derart ausgebildet und/oder dazu dienen und/oder geeignet sind, dass sie für jede Kondensatordurchführung die jeweilige Oberkapazität C0a, C0b, C0c mit der jeweiligen Istkapazität COa', COb', COc' vergleichen;
- Mittel, die derart ausgebildet und/oder dazu dienen und/oder geeignet sind, dass sie ein Überwachungssignal erzeugen, dass von den Ergebnissen der Kapazitätsvergleiche abhängt.

Durch die Zusammenführung der Messspannungen in den Mitteln zum Erfassen der Messspannungen ist es möglich, eine zentrale Überwachung einzurichten und damit die Schwankungen der Netzspannungen in allen Strängen des Wechselstromnetzes bei der Überwachung aller Kondensatordurchführungen zu erfassen. Eine zuverlässige Überwachung der Kondensatordurchführungen wird damit gewährleistet.

Diese gemäß dem dritten Aspekt vorgeschlagene Vorrichtung kann die Oberkapazitäten der Kondensatordurchführungen sowie deren Istkapazitäten im Betrieb miteinander vergleichen, was hier auch als Kapazitätsvergleiche bezeichnet wird. Sollte sich eine Istkapazität verändern, kann auf eine Beschädigung der entsprechenden Kondensatordurchführung geschlossen werden.

Die gemäß dem dritten Aspekt vorgeschlagene Vorrichtung ermöglicht eine kontinuierliche Überwachung der Kondensatordurchführungen.

Mit der gemäß dem dritten Aspekt vorgeschlagenen Vorrichtung kann beispielsweise eines der vorgeschlagenen Verfahren durchgeführt werden.

Die gemäß dem dritten Aspekt vorgeschlagene Vorrichtung kann nach Bedarf auf beliebige Art und Weise ausgebildet sein, beispielsweise wie eine der gemäß dem zweiten Aspekt vorgeschlagenen Vorrichtungen.

Die Mittel zum Erfassen der Messspannungen können nach Bedarf auf beliebige Art und Weise ausgebildet sein und beispielsweise mit den Mitteln zum Berechnen der Istkapazitäten und/oder den Mitteln für die Kapazitätsvergleiche verbunden sein und/oder eine Messeinrichtung und/oder für jede Phase einen Messadapter aufweisen, der mit dem Belag der zu der jeweiligen Phase gehörenden Kondensatordurchführung verbunden werden kann und mit der Messeinrichtung verbunden ist, um die jeweilige Messspannung zu erfassen und/oder zu messen.

Die Mittel zum Berechnen der Istkapazitäten können nach Bedarf auf beliebige Art und Weise ausgebildet sein und beispielsweise mit den Mitteln zum Erfassen der Messspannungen und/oder den Mitteln für die Kapazitätsvergleiche verbunden sein und/oder eine Auswerteeinrichtung aufweisen, die mit der Messeinrichtung verbunden ist, um die Messspannungen an die Auswerteeinrichtung zu übermitteln.

Es kann beispielsweise für jeden Messadapter eine eigene Messeinrichtung und/oder eine eigene Auswerteeinrichtung vorgesehen sein. Alternativ kann die Messeinrichtung als gemeinsame Messeinrichtung für wenigstens zwei oder für alle Messadapter ausgebildet sein.

Die Mittel für die Kapazitätsvergleiche können nach Bedarf auf beliebige Art und Weise ausgebildet sein und beispielsweise mit den Mitteln zum Erfassen der Messspannungen und/oder den Mitteln zum Berechnen der Istkapazitäten verbunden sein und/oder die Auswerteeinrichtung der Mittel zum Berechnen der Istkapazitäten und/oder eine eigene Auswerteeinrichtung aufweisen und/oder mit den Mitteln zum Berechnen der Istkapazitäten zu einem gemeinsamen Mittel zusammengefasst oder kombiniert sein oder durch die Mittel zum Berechnen der Istkapazitäten realisiert sein oder in den Mitteln zum Berechnen der Istkapazitäten enthalten sein oder die Mittel zum Berechnen der Istkapazitäten enthalten.

Die Mittel zum Erzeugen des Überwachungssignals können nach Bedarf auf beliebige Art und Weise ausgebildet sein und beispielsweise mit den Mitteln für die Kapazitätsvergleiche verbunden sein und/oder wenigstens einen akustische Signalgeber und/oder wenigstens einen optischen Signalgeber und/oder wenigstens einen elektronischen Signalgeber aufweisen und/oder in den Mitteln zum Berechnen der Istkapazitäten und/oder in den Mitteln für die Kapazitätsvergleiche enthalten sein.

Es kann vorgesehen sein, dass die gemäß dem dritten Aspekt vorgeschlagene Vorrichtung zusätzlich aufweist oder umfasst

- Mittel, die derart ausgebildet und/oder dazu dienen und/oder geeignet sind, dass sie die Netzspannungen Ua, Ub, Uc einer jeden Phase erfassen und/oder messen;
- Mittel, die derart ausgebildet und/oder dazu dienen und/oder geeignet sind, dass sie die Netzspannungen untereinander vergleichen;
- Mittel, die derart ausgebildet und/oder dazu dienen und/oder geeignet sind, dass sie, falls der Spannungsvergleich ergibt, dass die Netzspannungen nicht mehr als ein vorbestimmtes Maß UAB, UBC, UCA voneinander abweichen, dann das Berechnen der Istkapazitäten, das Vergleichen der Kapazitäten und das Erzeugen des Überwachungssignals veranlassen oder ausführen oder durchführen oder starten.

Durch die Verwendung der Netzspannungen können zeitliche Änderungen und/oder Schwankungen der Netzspannungen, wie beispielsweise transiente Phänomene oder Asymmetrien, erfasst und/oder erkannt werden und beispielsweise mit den Messspannungen und/oder deren zeitliche Änderungen und/oder Schwankungen verglichen werden. Eine zuverlässige Überwachung der Kondensatordurchführungen unter Berücksichtigung und Bewertung der Änderungen und/oder Schwankungen der Netzspannungen wird damit gewährleistet.

Dieses Vergleichen der Netzspannungen, was hier auch als Spannungsvergleich bezeichnet wird, ermöglicht, dass ein Zeitpunkt bestimmt wird, zu dem die eigentliche Überwachung, nämlich das Berechnen der Istkapazitäten, die Kapazitätsvergleiche und das Erzeugen des Überwachungssignals, besonders vorteilhaft oder günstig ist, da sie dann nicht durch über das vorbestimmte Maß hinaus voneinander abweichende Netzspannungen erschwert, behindert oder gar unmöglich gemacht wird. Damit wird erreicht, dass unabhängig von Schwankungen der Netzspannungen sowie von Messtoleranzen beim Erfassen der Messspannungen eine bessere Aussage über den Zustand der Kondensatordurchführungen getroffen werden kann.

Durch die Berücksichtigung der Netzspannungen können beispielsweise zeitliche Änderungen der Spannungsverhältnisse, die auch als Asymmetrien bezeichnet werden, erfasst werden und somit die entsprechenden Abweichungen der an den Kondensatordurchführungen abgegriffenen Messspannungen zumindest teilweise kompensiert werden. Damit wird eine zuverlässige Überwachung der Kondensatordurchführungen unter Berücksichtigung und Bewertung der Abweichungen und der Störungen der Netzspannungen gewährleistet.

Die Mittel zum Veranlassen des Berechnens der Istkapazitäten, des Vergleichens der Kapazitäten und des Erzeugens des Überwachungssignals werden hier auch kurz als Mittel zum Veranlassen bezeichnet.

Die Mittel zum Erfassen der Netzspannungen können nach Bedarf auf beliebige Art und Weise ausgebildet sein und beispielsweise mit den Mitteln für den Spannungsvergleich verbunden sein und/oder für jede Phase einen Spannungswandler aufweisen, der mit der zu der jeweiligen Phase gehörenden Netzleitung verbunden werden kann, um die jeweilige Messspannung zu erfassen und/oder zu messen. Sie können beispielsweise zusätzlich mit den Mitteln zum Berechnen der Istkapazitäten und/oder den Mitteln für die Kapazitätsvergleiche verbunden sein.

Die Mittel für den Spannungsvergleich können nach Bedarf auf beliebige Art und Weise ausgebildet sein und beispielsweise mit den Mitteln zum Erfassen der Netzspannungen und/oder den Mitteln zum Veranlassen verbunden sein und/oder die Auswerteeinrichtung der Mittel zum Berechnen der Istkapazitäten und/oder die Auswerteeinrichtung der Mittel für die Kapazitätsvergleiche und/oder eine eigene Auswerteeinrichtung aufweisen, die mit den Mitteln zum Erfassen der Netzspannungen und/oder den Spannungswandlern verbunden ist. Sie können beispielsweise zusätzlich mit den Mitteln zum Berechnen der Istkapazitäten und/oder den Mitteln für die Kapazitätsvergleiche verbunden sein. Alternativ oder zusätzlich können sie mit den Mitteln zum Berechnen der Istkapazitäten und/oder den Mitteln für die Kapazitätsvergleiche und/oder den Mitteln zum Veranlassen zu einem gemeinsamen Mittel zusammengefasst oder kombiniert sein oder durch die Mittel zum Berechnen der Istkapazitäten und/oder die Mittel für die Kapazitätsvergleiche und/oder die Mittel zum Veranlassen realisiert sein oder in den Mitteln zum Berechnen der Istkapazitäten und/oder den Mitteln für die Kapazitätsvergleiche und/oder den Mitteln zum Veranlassen enthalten sein oder die Mittel zum Berechnen der Istkapazitäten und/oder die Mittel für die Kapazitätsvergleiche und/oder die Mittel zum Veranlassen enthalten.

Die Mittel zum Veranlassen können nach Bedarf auf beliebige Art und Weise ausgebildet sein und beispielsweise mit den Mitteln für den Spannungsvergleich und/oder den Mitteln zum Berechnen der Istkapazitäten und/oder den Mitteln für die Kapazitätsvergleiche und/oder den Mitteln zum Erzeugen des Überwachungssignals verbunden sein und/oder die Auswerteeinrichtung der Mittel für den Spannungsvergleich und/oder die Auswerteeinrichtung der Mittel zum Berechnen der Istkapazitäten und/oder die Auswerteeinrichtung der Mittel für die Kapazitätsvergleiche und/oder eine eigene Auswerteeinrichtung aufweisen, die mit den Mitteln für den Spannungsvergleich und/oder den Mitteln zum Berechnen der Istkapazitäten und/oder den Mitteln für die Kapazitätsvergleiche und/oder den Mitteln zum Erzeugen des Überwachungssignals verbunden ist. Alternativ oder zusätzlich können sie mit den Mitteln für den Spannungsvergleich und/oder den Mitteln zum Berechnen der Istkapazitäten und/oder den Mitteln für die Kapazitätsvergleiche zu einem gemeinsamen Mittel zusammengefasst oder kombiniert sein oder durch die Mittel für den Spannungsvergleich und/oder die Mittel zum Berechnen der Istkapazitäten und/oder die Mittel für die Kapazitätsvergleiche realisiert sein oder in den Mitteln für den Spannungsvergleich und/oder den Mitteln zum Berechnen der Istkapazitäten und/oder den Mitteln für die Kapazitätsvergleiche enthalten sein oder die Mittel für den Spannungsvergleich und/oder die Mittel zum Berechnen der Istkapazitäten und/oder die Mittel für die Kapazitätsvergleiche enthalten.

Es kann vorgesehen sein, dass

- jede der vorgeschlagenen Vorrichtungen derart ausgebildet ist und/oder dazu dient und/oder geeignet ist, dass sie eines der vorgeschlagenen Verfahren ausführt und/oder ausführen kann.

Jedes der gemäß dem ersten Aspekt vorgeschlagenen Verfahren sowie jede der gemäß dem zweiten oder dritten Aspekt vorgeschlagenen Vorrichtungen ermöglicht die Verwendung von Spannungswandlern, die relativ große Messtoleranzen und/oder Messgenauigkeiten haben und vorzugsweise der gleichen Toleranzklasse und/oder Genauigkeitsklasse angehören und insbesondere baugleich sind.

Die Ausführungen und Erläuterungen zu einem der Aspekte der Erfindung, insbesondere zu einzelnen Merkmalen dieses Aspektes, gelten entsprechend auch analog für die anderen Aspekte der Erfindung.

Im Folgenden werden Ausführungsformen der Erfindung beispielhaft anhand der beigefügten Zeichnungen näher erläutert. Die daraus hervorgehenden einzelnen Merkmale sind jedoch nicht auf die einzelnen Ausführungsformen beschränkt, sondern können mit weiter oben beschriebenen einzelnen Merkmalen und/oder mit einzelnen Merkmalen anderer Ausführungsformen verbunden und/oder kombiniert werden. Die Einzelheiten in den Zeichnungen sind nur erläuternd, nicht aber beschränkend auszulegen. Die in den Ansprüchen enthaltenen Bezugszeichen sollen den Schutzbereich der Erfindung in keiner Weise beschränken, sondern verweisen lediglich auf die in den Zeichnungen gezeigten Ausführungsformen. Die Zeichnungen zeigen in

FIG. 1 eine Ausführungsform einer Vorrichtung zur Überwachung von Kondensatordurchführungen für ein dreiphasiges Wechselstromnetz;

FIG. 2 einen Teil der Vorrichtung der FIG. 1;

FIG. 3 eine Ersatzschaltung aus einem Unterspannungskondensator und einem Oberspannungskondensator;

FIG. 4 ein Ablaufdiagramm einer Ausführungsform eines Verfahrens zur Überwachung von Kondensatordurchführungen für ein dreiphasiges Wechselstromnetz.

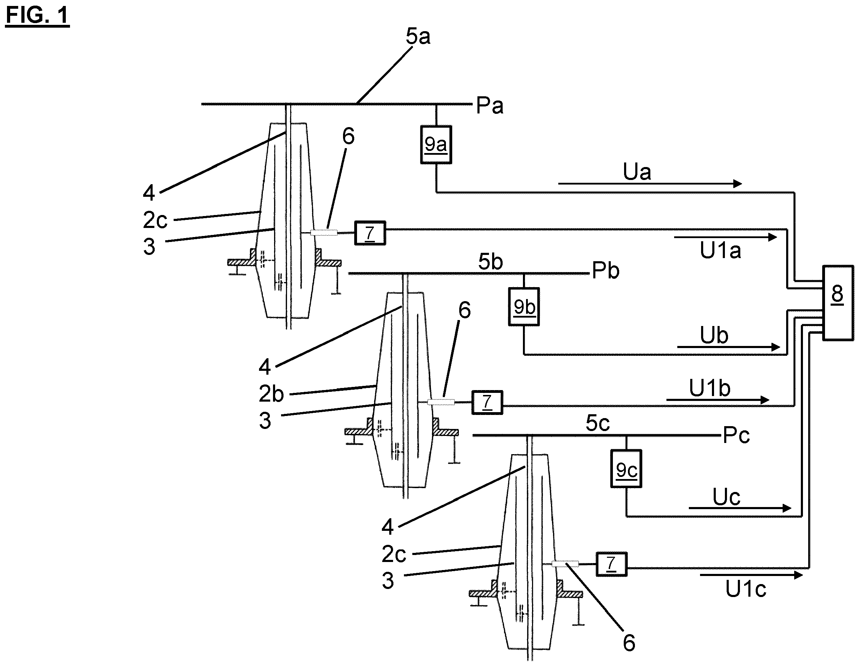

In der FIG. 1 ist eine Ausführungsform einer Vorrichtung 1 zur Überwachung von Kondensatordurchführungen 2a, 2b, 2c für ein dreiphasiges Wechselstromnetz schematisch dargestellt. Die Kondensatordurchführungen 2a, 2b, 2c gehören bei dieser Ausführungsform zu einem hier nicht dargestellten Transformator, der hier beispielhaft ein Hochspannungstransformator ist. Derartige Kondensatordurchführungen 2a, 2b, 2c werden beispielsweise bei hohen Spannungen im Bereich von einigen wenigen kV bis zu einigen 1000 kV eingesetzt. Das Wechselstromnetz ist hier beispielhaft ein Hochspannungsnetz. Jede der drei Kondensatordurchführungen 2a, 2b, 2c ist einer der drei Phasen Pa, Pb, Pc des Wechselstromnetzes zugeordnet und weist einen Leiter 4, der mit der jeweiligen Netzleitung 5a, 5b, 5c des Wechselstromnetzes verbunden ist, und mehrere elektrisch leitfähige Beläge auf, die den Leiter 4 in mehreren Lagen oder Schichten umgeben und von denen lediglich der äußerste Belag 3 dargestellt ist.

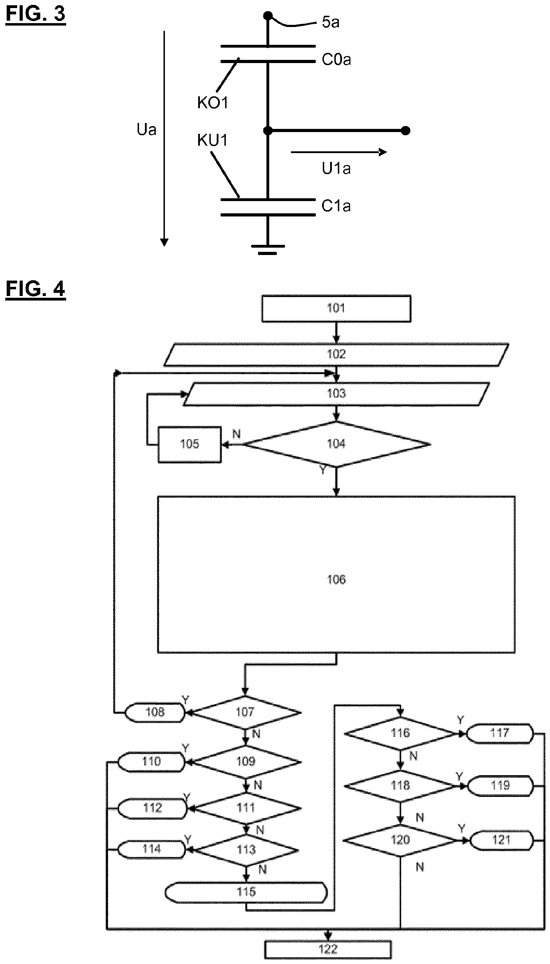

Die Vorrichtung weist 1 eine Auswerteeinrichtung 8 sowie für jede Phase Pa, Pb, Pc eine Messeinrichtung 7 und einen Messadapter 6 auf, der mit dem Belag 3 der zu der jeweiligen Phase gehörenden Kondensatordurchführung 2a, 2b, 2c verbunden ist und mit der jeweiligen Messeinrichtung 7 verbunden ist, um eine erste elektrische Messgröße für die jeweilige Phase Pa, Pb, Pc zu erfassen. Diese ersten Messgrößen sind hier elektrische Spannungen, die jeweils an einem weiter unten beschriebenen und in FIG. 3 gezeigten Unterspannungskondensator KU1, KU2, KU3 der jeweiligen Phase Pa, Pb, Pc anliegen und hier auch als Messspannungen U1a, U1b, U1c bezeichnet werden. Die Auswerteeinrichtung 8 ist mit jeder Messeinrichtung 7 verbunden, um die Messspannungen U1a, U1b, U1c an die Auswerteeinrichtung 8 zu übermitteln, und bildet somit eine gemeinsame Auswerteeinrichtung 8 für alle Messeinrichtungen 7.

Bei dieser Ausführungsform weist die Vorrichtung 1 zudem für jede Phase Pa, Pb, Pc einen Spannungswandler 9a, 9b, 9c auf, der mit der jeweiligen Netzleitung 5a, 5b, 5c verbunden ist, um eine zweite elektrische Messgröße für die jeweilige Phase Pa, Pb, Pc zu erfassen. Diese zweiten Messgrößen sind hier elektrische Spannungen, die jeweils an der jeweiligen Netzleitung 5a, 5b, 5c und Massepotenzial 13 anliegen und hier auch als Netzspannungen Ua, Ub, Uc bezeichnet werden. Die Auswerteeinrichtung 8 ist mit jedem Spannungswandler 9a, 9b, 9c verbunden, um die Netzspannungen Ua, Ub, Uc an die Auswerteeinrichtung 8 zu übermitteln, und bildet somit eine gemeinsame Auswerteeinrichtung 8 für alle Spannungswandler 9a, 9b, 9c.

Durch die Vorrichtung 1 wird die Möglichkeit geschaffen, dass die Auswerteeinrichtung 8 bei der Überwachung der Kondensatordurchführungen 2a, 2b, 2c Asymmetrien und/oder Schwankungen der Netzspannungen Ua, Ub, Uc auf den Netzleitungen 5a, 5b, 5c berücksichtigt.

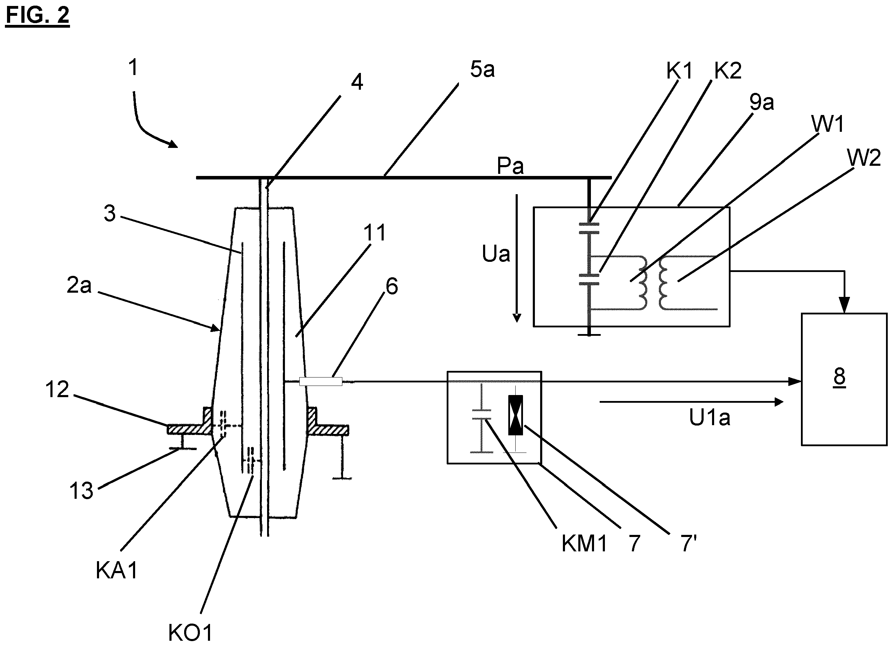

In der FIG. 2 ist ein erster Teil der Vorrichtung 1 detaillierter dargestellt, der einer ersten Phase Pa zugeordnet ist. Diesem ersten Teil entsprechen ein einer zweiten Phase Pb zugeordneter zweiter und ein einer dritten Phase Pc zugeordneter dritter Teil der Vorrichtung 1 analog, sodass die Ausführungen und Erläuterungen zu dem ersten Teil entsprechend auch analog für diese beiden anderen Teile gelten.

Die der ersten Phase Pa zugeordnete erste Kondensatordurchführung 2a weist einen Isolationskörper 11 auf, durch dessen Inneres der Leiter 4 geführt ist. Dieser kontaktiert an seinem oberen Ende die seiner Kondensatordurchführung 2a zugeordnete Netzleitung 5a und an seinem unteren Ende eine hier nicht dargestellte Wicklung des Hochspannungstransformators. Im Isolierkörper 11 sind die elektrisch leitfähigen Beläge eingebettet, die hier nur durch den äußersten Belag 3 angedeutet sind und elektrisch gesehen eine Reihenschaltung von Kondensatoren bilden. Diese Reihenschaltung weist die Kondensatoren, die jeweils von zwei benachbarten Belägen gebildet werden, sowie einen Kondensator auf, der von dem hier nicht gezeigten innersten Belag und dem Leiter 4 gebildet wird. Diese Reihenschaltung von Kondensatoren zwischen dem äußersten Belag 3 und dem Leiter 4 bildet als Ersatzschaltung für jede Kondensatordurchführung 2a, 2b, 2c einen entsprechenden Oberspannungskondensator KO1, KO2, KO3 mit einer Kapazität, die als Oberkapazität C0a, C0b, C0c bezeichnet wird.

An der Kondensatordurchführung 2a ist ein elektrisch leitfähiger Flansch 12 angeordnet, der am Erdpotenzial oder Massepotenzial 13 anliegt. Dieser Flansch 12 dient der Befestigung und/oder Sicherung der Kondensatordurchführung 2a. Der äußerste Belag 3 bildet mit dem Flansch 12 und Massepotenzial 13 als Ersatzschaltung für jede Kondensatordurchführung 2a, 2b, 2c einen entsprechenden Außenkondensator KA1, KA2, KA3 mit der Kapazität CA1, CA2, CA3.

Der Messadapter 6 dringt durch den Isolationskörper 11 und stellt eine elektrisch leitende Verbindung zum äußersten Belag 3 her. Er ist elektrisch leitend über die jeweilige Messeinrichtung 7 mit der Auswerteeinrichtung 8 verbunden, um die Messspannung U1a erfassen und an die Auswerteeinrichtung 8 übermitteln zu können. Bei dieser Ausführungsform weist jede Messeinrichtung 7 einen Messkondensator KM1, KM2, KM3 mit einer Kapazität CM1, CM2, CM3 auf, der auf Massepotenzial 13 geschaltet ist. Sie kann bei Bedarf zusätzlich eine nicht dargestellte Funkenstrecke, die parallel zu dem jeweiligen Messkondensator KM1, KM2, KM3 geschaltet ist, und/oder einen Überspannungsschutz 7' aufweisen, der parallel zu dem jeweiligen Messkondensator KM1, KM2, KM3 geschaltet ist.

Die Auswerteeinrichtung 8 ist über den Spannungswandler 9a mit der Netzleitung 5a elektrisch leitend verbunden. Durch diese Verbindung wird die Spannung Ua erfasst, die zwischen der Netzleitung 5a und dem Massepotenzial 13 anliegt. Bei dieser Ausführungsform ist der Spannungswandler 9a als kapazitiver Spannungswandler ausgebildet und weist einen kapazitiven Spannungsteiler, der zwei in Reihe geschaltete Kondensatoren K1, K2 aufweist, und zwei Spulen oder Wicklungen W1, W2 auf, die als Transformator zur induktiven galvanischen Trennung geschaltet sind.

Diese Vorrichtung 1 ist geeignet und/oder kann derart ausgebildet sein, dass sie ein Verfahren zur Überwachung von Kondensatordurchführungen für ein dreiphasiges Wechselstromnetz ausführt. Eine Ausführungsform eines derartigen Verfahrens wird weiter unten beschrieben.

In der FIG. 3 ist für die erste Phase Pa eine Ersatzschaltung aus dem jeweiligen Unterspannungskondensator KU1 und dem jeweiligen Oberspannungskondensator KO1 schematisch dargestellt. Eine Parallelschaltung, die den jeweiligen Messkondensator KM1 und den Außenkondensator KA1 aufweist, bildet den Unterspannungskondensator KU1 mit der Unterkapazität C1. Diese Unterkapazität C1 kann daher mit der bekannten Formel für die Reihenschaltung von Kondensatoren leicht aus der Kapazität CM1 des Messkondensators KM1 und der Kapazität CA1 des Außenkondensators KA1 berechnet werden. Bei Bedarf kann die Parallelschaltung anstelle des Messkondensators KM1 die gesamte jeweilige Messeinrichtung 7 und/oder zusätzlich die Auswerteeinrichtung 8 aufweisen, sodass dann die Kapazität CA1 aus der Impedanz der Messeinrichtung 7, die von der Kapazität CM1 abhängt, der Kapazität CA1 und der Impedanz der Auswerteeinrichtung 8 berechnet werden muss.

Die Messspannung U1a liegt wie oben erwähnt am Unterspannungskondensator KU1 an und wird an der Verbindungsleitung oder der Verbindungsstelle zwischen dem Unterspannungskondensator KU1 und dem Oberspannungskondensator KO1 abgegriffen und auf Massepotenzial 13 bezogen ist. Die Netzspannung Ua fällt über der Reihenschaltung aus dem Oberspannungskondensator KO1 und dem Unterspannungskondensator KU1 ab.

In der FIG. 4 ist ein Ablaufdiagramm einer Ausführungsform eines Verfahrens zur Überwachung von Kondensatordurchführungen 2a, 2b, 2c für ein dreiphasiges Wechselstromnetz schematisch dargestellt. Dieses Verfahren kann beispielsweise durch die und/oder mithilfe der Vorrichtung 1 der FIG. 1 ausgeführt werden.

Bei dieser Ausführungsform weist das Verfahren die folgenden Schritte auf, die unter Bezugnahme auf die Vorrichtung 1 und die FIG. 1 und 2 erläutert werden:

Schritt 101: Start des Verfahrens.
Schritt 102: Für jede Kondensatordurchführung 2a, 2b, 2c werden die Oberkapazität C0a, C0b, C0c und die Unterkapazität C1a, C1b, C1c ermittelt. Diese sind als feste Werte hinterlegt.
Schritt 103: An jeder Kondensatordurchführung 2a, 2b, 2c wird die Messspannung U1a, U1b, U1c erfasst. Für jede Phase Pa, Pb, Pc wird die Netzspannung Ua, Ub, Uc erfasst.
Schritt 104: Die Netzspannungen Ua, Ub, Uc werden in Effektivwerte Uae, Ube, Uce umgerechnet und untereinander verglichen.

Bei dieser Ausführungsform ist vorgesehen, dass Toleranzwerte UAB > 0, UBC > 0, UCA > 0 für den Spannungsvergleich bestimmt werden und der Spannungsvergleich derart erfolgt, dass geprüft wird, ob

$$|Uae - Ube| \leq UAB \text{ und } |Ube - Uce| \leq UBC \text{ und } |Uce - Uae| \leq UCA$$

gilt.

Falls ja, dann bedeutet dies, dass der Spannungsvergleich ergibt, dass die Netzspannungen Ua, Ub, Uc nicht mehr als ein vorbestimmtes Maß UAB, UBC, UCA voneinander abweichen. In diesem Fall wird der Schritt 106 ausgeführt.

Falls nein, dann bedeutet dies, dass der Spannungsvergleich ergibt, dass die Netzspannungen Ua, Ub, Uc mehr als ein vorbestimmtes Maß UAB, UBC, UCA voneinander abweichen. In diesem Fall wird der Schritt 105 ausgeführt.

Schritt 105: Ein Warnsignal wird erzeugt, das einen Kurzschluss im Stromnetz und/oder eine zu starke oder übermäßige Asymmetrie von Netzspannungen Ua, Ub, Uc anzeigt. Anschließend erfolgt Sprung zu Schritt 103.

Schritt 106: Für jede Kondensatordurchführung 2a, 2b, 2c wird eine Istkapazität COa', COb', COc' berechnet, die von der jeweiligen Messspannung U1a, U1b, U1c, der jeweiligen Unterkapazität C1a, C1b, C1c sowie von der Messspannung U1b, U1c, U1a, der Unterkapazität C1b, C1c, C1a, und der Oberkapazität C0b, C0c, C0a einer der anderen Kondensatordurchführungen 2b, 2c, 2a abhängt.

Bei dieser Ausführungsform ist vorgesehen, dass die Istkapazitäten COa', COb', COc' der Kondensatordurchführungen 2a, 2b, 2c mit folgenden Formeln berechnet werden:

$$C_{0a}{}' = C_{1a} \times \frac{U_{1a} \times K_a}{\dfrac{U_{1b} \times C_{1b}}{C_{0b}} + U_{1b} - U_{1a} \times K_a}$$

worin Ka ein Korrekturwert ist, für den Ka = Ub/Ua gilt;

$$C_{0b}{}' = C_{1b} \times \frac{U_{1b} \times K_b}{\dfrac{U_{1c} \times C_{1c}}{C_{0c}} + U_{1c} - U_{1b} \times K_b}$$

worin Kb ein Korrekturwert ist, für den Kb = Uc/Ub gilt;

$$C_{0c}{}' = C_{1c} \times \frac{U_{1c} \times Kc}{\dfrac{U_{1a} \times C_{1a}}{C_{0a}} + U_{1a} - U_{1c} \times Kc}$$

worin Kc ein Korrekturwert ist, für den Kc = Ua/Uc gilt.

Schritt 107: Für jede Kondensatordurchführung 2a, 2b, 2c wird die jeweilige Oberkapazität C0a, C0b, C0c mit der jeweiligen Istkapazität COa', COb', COc' verglichen.

Bei dieser Ausführungsform ist vorgesehen, dass Toleranzwerte CA > 0, CB > 0, CC > 0 für die Kapazitätsvergleiche bestimmt werden und die Kapazitätsvergleiche derart erfolgen, dass zunächst geprüft wird, ob

$$|C0a' - C0a| \leq CA \text{ und } |C0b' - C0b| \leq CB \text{ und } |C0c' - C0c| \leq CC$$

gilt. Falls ja, wird der Schritt 108 ausgeführt. Falls nein, wird der Schritt 109 ausgeführt.

Schritt 108: Ein Überwachungssignal wird erzeugt, das anzeigt, dass die Kondensatordurchführungen 2a, 2b, 2c in ordnungsgemäßem Zustand sind. Anschließend erfolgt Sprung zu Schritt 103.

Schritt 109: Die Kapazitätsvergleiche erfolgen außerdem derart, dass geprüft wird, ob

$$C0a' - C0a < -CA \text{ und } C0b' - C0b > CB \text{ und } |C0c' - C0c| \leq CC$$

gilt. Falls ja, wird der Schritt 110 ausgeführt. Falls nein, wird der Schritt 111 ausgeführt.

Schritt 110: Ein Überwachungssignal wird erzeugt, das anzeigt, dass zumindest die zweite Kondensatordurchführung 2b nicht in ordnungsgemäßem Zustand ist. Anschließend erfolgt Sprung zu Schritt 122.

Schritt 111: Die Kapazitätsvergleiche erfolgen außerdem derart, dass geprüft wird, ob

$$C0b' - C0b < -CB \text{ und } C0c' - C0c > CC \text{ und } |C0a' - C0a| \leq CA$$

gilt. Falls ja, wird der Schritt 112 ausgeführt. Falls nein, wird der Schritt 113 ausgeführt.

Schritt 112: Ein Überwachungssignal wird erzeugt, das anzeigt, dass zumindest die dritte Kondensatordurchführung 2c nicht in ordnungsgemäßem Zustand ist. Anschließend erfolgt Sprung zu Schritt 122.

Schritt 113: Die Kapazitätsvergleiche erfolgen außerdem derart, dass geprüft wird, ob

$$C0c' - C0c < -CC \text{ und } C0a' - C0a > CA \text{ und } |C0b' - C0b| \leq CB$$

gilt. Falls ja, wird der Schritt 114 ausgeführt. Falls nein, wird der Schritt 115 ausgeführt.

Schritt 114: Ein Überwachungssignal wird erzeugt, das anzeigt, dass zumindest die erste Kondensatordurchführung 2a nicht in ordnungsgemäßem Zustand ist. Anschließend erfolgt Sprung zu Schritt 122.

Schritt 115: Ein Überwachungssignal wird erzeugt, das anzeigt, dass zumindest zwei Kondensatordurchführungen nicht in ordnungsgemäßem Zustand sind.

Schritt 116: Die Kapazitätsvergleiche erfolgen außerdem derart, dass geprüft wird, ob

$$C0a' - C0a > CA \text{ und } C0b' - C0b < -CB \text{ und } |C0c' - C0c| \leq CC$$

gilt. Falls ja, wird der Schritt 117 ausgeführt. Falls nein, wird der Schritt 118 ausgeführt.

Schritt 117: Ein Überwachungssignal wird erzeugt, das anzeigt, dass die erste und die dritte Kondensatordurchführung 2a, 2c nicht in ordnungsgemäßem Zustand sind und einen gleichartigen Fehler haben. Anschließend erfolgt Sprung zu Schritt 122.

Schritt 118: Die Kapazitätsvergleiche erfolgen außerdem derart, dass geprüft wird, ob

$$C0b' - C0b > CB \text{ und } C0c' - C0c < -CC \text{ und } |C0a' - C0a| \leq CA$$

gilt. Falls ja, wird der Schritt 119 ausgeführt. Falls nein, wird der Schritt 120 ausgeführt.

Schritt 119: Ein Überwachungssignal wird erzeugt, das anzeigt, dass die zweite und die erste Kondensatordurchführung 2b, 2a nicht in ordnungsgemäßem Zustand sind und einen gleichartigen Fehler haben. Anschließend erfolgt Sprung zu Schritt 122.

Schritt 120: Die Kapazitätsvergleiche erfolgen außerdem derart, dass geprüft wird, ob

$$C0c' - C0c > CC \text{ und } C0a' - C0a < -CA \text{ und } |C0b' - C0b| \leq CB$$

gilt. Falls ja, wird der Schritt 121 ausgeführt. Falls nein, wird der Schritt 122 ausgeführt.

Schritt 121: Ein Überwachungssignal wird erzeugt, das anzeigt, dass die dritte und die zweite Kondensatordurchführung 2c, 2b nicht in ordnungsgemäßem Zustand sind und einen gleichartigen Fehler haben. Anschließend erfolgt Sprung zu Schritt 122.

Schritt 122: Ein Überwachungssignal wird erzeugt, das anzeigt, dass wenigstens zwei Kondensatordurchführungen nicht in ordnungsgemäßem Zustand sind und einen nicht gleichartigen Fehler haben. Anschließend wird das Verfahren beendet oder erfolgt nach Bedarf Sprung zu Schritt 103.

Schritt 102 kann beispielsweise durch die Auswerteeinrichtung 8 ausgeführt werden.

Schritt 103 kann beispielsweise zum Einen durch die Messadapter 6, die Messeinrichtungen 7 und die Auswerteeinrichtung 8 ausgeführt werden, die somit zusammen Mittel bilden, die derart ausgebildet sind, dass sie an jeder Kondensatordurchführung 2a, 2b, 2c eine Messspannung U1a, U1b, U1c erfassen, die zwischen dem jeweiligen Belag 3 und einem Massepotenzial 13 anliegt, und zum Anderem durch die Spannungswandler 9a, 9b, 9c und die Auswerteeinrichtung 8, die somit zusammen Mittel bilden, die derart ausgebildet sind, dass sie die Netzspannungen Ua, Ub, Uc einer jeden Phase Pa, Pb, Pc erfassen.

Schritte 104 und 105 können beispielsweise durch die Auswerteeinrichtung 8 ausgeführt werden, die somit Mittel bildet, die derart ausgebildet sind, dass sie die Netzspannungen Ua, Ub, Uc untereinander vergleichen.

Schritt 106 kann beispielsweise durch die Auswerteeinrichtung 8 ausgeführt werden, die somit Mittel bildet, die derart ausgebildet sind, dass sie für jede Kondensatordurchführung 2a eine Istkapazität COa', COb', COc' berechnen, die von der jeweiligen Messspannung U1a, U1b, U1c, einer Unterkapazität C1a, C1b, C1c der jeweiligen Kondensatordurchführung 2a, 2b, 2c sowie von der Messspannung U1b, U1c, U1a, einer Unterkapazität C1b, C1c, C1a und einer Oberkapazität C0b, C0c, COa einer der anderen Kondensatordurchführungen 2b, 2c, 2a, abhängt.

Schritte 107, 109, 111, 113, 116, 118, 120 können beispielsweise durch die Auswerteeinrichtung 8 ausgeführt werden, die somit Mittel bildet, die derart ausgebildet sind, dass sie für jede Kondensatordurchführung 2a, 2b, 2c die jeweilige Oberkapazität C0a, C0b, COc mit der jeweiligen Istkapazität COa', COb', COc' vergleichen.

Schritte 108, 110, 112, 114, 115, 117, 119, 121, 122 können beispielsweise durch die Auswerteeinrichtung 8 ausgeführt werden, die somit Mittel bildet, die derart ausgebildet sind, dass sie ein Überwachungssignal erzeugen, dass von den Ergebnissen der Kapazitätsvergleiche abhängt.

**BEZUGSZEICHEN**

| | |
|---|---|
| 1 | Vorrichtung |
| 2a, 2b, 2c | Kondensatordurchführung |
| 3 | Belag |
| 4 | Leiter |
| 5a, 5b, 5c | Netzleitung |
| 6 | Messadapter |
| 7 | Messeinrichtung |
| 7' | Überspannungsschutz |
| 8 | Auswerteeinrichtung |
| 9a, 9b, 9c | Spannungswandler |
| 11 | Isolationskörper |
| 12 | Flansch |
| 13 | Massepotential |
| K1, K2 | Kondensatoren |
| W1, W2 | Wicklungen |
| Pa, Pb, Pc | erste, zweite, dritte Phase |
| Ua, Ub, Uc | Netzspannung |
| Uae, Ube, Uce | Effektivwerte der Netzspannung |
| SP1, SP2 SP3 | Spannungsteiler |
| KO1, KO2, KO3 | erster, zweiter, dritter Oberspannungskondensator |
| KU1, KU2, KU3 | erster, zweiter, dritter Unterspannungskondensator |
| KA1, KA2, KA3 | erster, zweiter, dritter Außenkondensator |
| KM1, KM2, KM3 | erster, zweiter, dritter Messkondensator |
| C0a, C0b, COc | Oberkapazität von KO1, KO2, KO3 |
| COa', COb', COc' | Istkapazität von KO1, KO2, KO3 |
| C1a, C1b, C1c | Unterkapazität von KU1, KU2, KU3 |
| CA1, CA2, CA3 | Kapazität von KA1, KA2, KA3 |
| CM1, CM2, CM3 | Kapazität von KM1, KM2, KM3 |
| U1a, U1b, U1c | Messspannungen an 6 |
| Ka, Kb, Kc | Korrekturwert |
| CA, CB, CC | Toleranzwerte für Kapazitätsvergleiche |
| UAB, UBC, UCA | Toleranzwerte für Spannungsvergleiche |

**Patentansprüche**

1. Verfahren zur Überwachung von Kondensatordurchführungen (2a, 2b, 2c) für ein dreiphasiges Wechselstromnetz, wobei jede Kondensatordurchführung (2a, 2b, 2c) einen Leiter (4), der mit einer der Netzleitungen (5a, 5b, 5c) des Wechselstromnetzes verbunden ist, und einen elektrisch leitfähigen Belag (3) aufweist, der den Leiter (4) umgibt, mit den Schritten, dass

- für jede Kondensatordurchführung (2a, 2b, 2c) eine Oberkapazität (COa, C0b, C0c) und eine Unterkapazität (C1a, C1b, C1c) ermittelt werden;
- an jeder Kondensatordurchführung (2a, 2b, 2c) eine Messspannung (U1a, U1b, U1c) erfasst wird, die zwischen dem jeweiligen Belag (3) und einem Massepotenzial (13) anliegt;

**dadurch gekennzeichnet, dass**

- für jede Kondensatordurchführung (2a, 2b, 2c) eine Istkapazität (COa', COb', COc') berechnet wird, die von der jeweiligen Messspannung (U1a, U1b, U1c), der jeweiligen Unterkapazität (C1a, C1b, C1c) sowie von der Messspannung (U1b, U1c, U1a), der Unterkapazität (C1b, C1c, C1a) und der Oberkapazität (COb, C0c, C0a) einer der anderen Kondensatordurchführungen (2b, 2c, 2a) abhängt;
- für jede Kondensatordurchführung (2a, 2b, 2c) die jeweilige Oberkapazität (COa, C0b, C0c) mit der jeweiligen Istkapazität (COa', COb', COc') verglichen wird;
- ein Überwachungssignal erzeugt wird, das von den Ergebnissen der Kapazitätsvergleiche abhängt.

2. Verfahren nach Anspruch 1, wobei

- für jede Phase (Pa, Pb, Pc) die Netzspannung (Ua, Ub, Uc) erfasst wird;
- die Netzspannungen (Ua, Ub, Uc) untereinander verglichen werden;
- falls der Spannungsvergleich ergibt, dass die Netzspannungen (Ua, Ub, Uc) nicht mehr als ein vorbestimmtes Maß (UAB, UBC, UCA) voneinander abweichen, dann das Berechnen der Istkapazitäten (COa', COb', COc'), das Vergleichen der Kapazitäten (COa, C0b, C0c, COa', COb', COc') und das Erzeugen des Überwachungssignals erfolgt.

3. Verfahren nach Anspruch 2, wobei

- beim Spannungsvergleich Effektivwerte (Uae, Ube, Uce) und/oder Scheitelwerte und/oder Amplituden der Netzspannungen (Ua, Ub, Uc) verwendet werden.

4. Verfahren nach Anspruch 3, wobei

- Toleranzwerte UAB > 0, UBC > 0, UCA > 0 für den Spannungsvergleich bestimmt werden;
- der Spannungsvergleich derart erfolgt, dass geprüft wird, ob

$$|Uae - Ube| \leq UAB \text{ und } |Ube - Uce| \leq UBC \text{ und } |Uce - Uae| \leq UCA$$

gilt.

5. Verfahren nach Anspruch 1, wobei

- die Istkapazität (COa') der ersten Kondensatordurchführung (2a) gemäß folgender Formel berechnet wird:

$$C_{0a}' = C_{1a} \times \frac{U_{1a} \times K_a}{\dfrac{U_{1b} \times C_{1b}}{C_{0b}} + U_{1b} - U_{1a} \times K_a}$$

worin Ka ein Korrekturwert ist, für den Ka = 1 oder Ka = Ub/Ua gilt; und/oder

- die Istkapazität (COb') der zweiten Kondensatordurchführung (2b) gemäß folgender Formel berechnet wird:

$$C_{0b}{}' = C_{1b} \times \dfrac{U_{1b} \times K_b}{\dfrac{U_{1c} \times C_{1c}}{C_{0c}} + U_{1c} - U_{1b} \times K_b}$$

worin Kb ein Korrekturwert ist, für den Kb = 1 oder Kb = Uc/Ub gilt; und/oder

- die Istkapazität (C0c') der dritten Kondensatordurchführung (2c) gemäß folgender Formel berechnet wird:

$$C_{0c}{}' = C_{1c} \times \dfrac{U_{1c} \times Kc}{\dfrac{U_{1a} \times C_{1a}}{C_{0a}} + U_{1a} - U_{1c} \times Kc}$$

worin Kc ein Korrekturwert ist, für den Kc = 1 oder Kc = Ua/Uc gilt.

6. Verfahren nach Anspruch 5, wobei

- Toleranzwerte CA > 0, CB > 0, CC > 0 für die Kapazitätsvergleiche bestimmt werden;
- falls die Kapazitätsvergleiche ergeben, dass

|C0a' − C0a| ≤ CA und |C0b' − C0b| ≤ CB und |C0c' − C0c| ≤ CC

gilt, dann ein Überwachungssignal erzeugt wird, das anzeigt, dass die Kondensatordurchführungen (2a, 2b, 2c) in ordnungsgemäßem Zustand sind.

7. Verfahren nach Anspruch 6, wobei

- andernfalls ein Überwachungssignal erzeugt wird, das anzeigt, dass zumindest eine Kondensatordurchführung nicht in ordnungsgemäßem Zustand ist.

8. Verfahren nach Anspruch 5, wobei

- Toleranzwerte CA > 0, CB > 0, CC > 0 für die Kapazitätsvergleiche bestimmt werden;
- falls die Kapazitätsvergleiche ergeben, dass

C0a' − C0a < −CA und C0b' − C0b > CB und |C0c' − C0c| ≤ CC

gilt, dann ein Überwachungssignal erzeugt wird, das anzeigt, dass zumindest die zweite Kondensatordurchführung (2b) nicht in ordnungsgemäßem Zustand ist;
- falls die Kapazitätsvergleiche ergeben, dass

C0b' − C0b < −CB und C0c' − C0c > CC und |C0a' − C0a| ≤ CA

gilt, dann ein Überwachungssignal erzeugt wird, das anzeigt, dass zumindest die dritte Kondensatordurchführung (2c) nicht in ordnungsgemäßem Zustand ist;
- falls die Kapazitätsvergleiche ergeben, dass

C0c' − C0c < −CC und C0a' − C0a > CA und |C0b' − C0b| ≤ CB

gilt, dann ein Überwachungssignal erzeugt wird, das anzeigt, dass zumindest die erste Kondensatordurchführung (2a) nicht in ordnungsgemäßem Zustand ist.

9. Verfahren nach Anspruch 8, wobei

- andernfalls ein Überwachungssignal erzeugt wird, das anzeigt, dass zumindest zwei Kondensatordurchführungen nicht in ordnungsgemäßem Zustand sind.

10. Verfahren nach Anspruch 5, wobei

- Toleranzwerte CA > 0, CB > 0, CC > 0 für die Kapazitätsvergleiche bestimmt werden;
- falls die Kapazitätsvergleiche ergeben, dass

$$C0a' - C0a > CA \text{ und } C0b' - C0b < -CB \text{ und } |C0c' - C0c| \leq CC$$

gilt, dann ein Überwachungssignal erzeugt wird, das anzeigt, dass die erste und die dritte Kondensatordurchführung (2a, 2c) nicht in ordnungsgemäßem Zustand sind und einen gleichartigen Fehler haben;
- falls die Kapazitätsvergleiche ergeben, dass

$$C0b' - C0b > CB \text{ und } C0c' - C0c < -CC \text{ und } |C0a' - C0a| \leq CA$$

gilt, dann ein Überwachungssignal erzeugt wird, das anzeigt, dass die zweite und die erste Kondensatordurchführung (2b, 2a) nicht in ordnungsgemäßem Zustand sind und einen gleichartigen Fehler haben;
- falls die Kapazitätsvergleiche ergeben, dass

$$C0c' - C0c > CC \text{ und } C0a' - C0a < -CA \text{ und } |C0b' - C0b| \leq CB$$

gilt, dann ein Überwachungssignal erzeugt wird, das anzeigt, dass die dritte und die zweite Kondensatordurchführung (2c, 2b) nicht in ordnungsgemäßem Zustand sind und einen gleichartigen Fehler haben.

11. Vorrichtung (1) zur Überwachung von Kondensatordurchführungen (2a, 2b, 2c) für ein dreiphasiges Wechselstromnetz, wobei jede Kondensatordurchführung (2a, 2b, 2c) einen Leiter (4), der mit einer der Netzleitungen (5a, 5b, 5c) des Wechselstromnetzes verbunden ist, und einen elektrisch leitfähigen Belag (3) aufweist, der den Leiter (4) umgibt, , aufweisend

- Mittel, die derart ausgebildet sind, dass sie an jeder Kondensatordurchführung (2a, 2b, 2c) eine Messspannung (U1a, U1b, U1c) erfassen, die zwischen dem jeweiligen Belag (3) und einem Massepotenzial (13) anliegt; **gekennzeichnet durch**
- Mittel, die derart ausgebildet sind, dass sie für jede Kondensatordurchführung (2a) eine Istkapazität (COa', COb', COc') berechnen, die von der jeweiligen Messspannung (U1a, U1b, U1c), einer Unterkapazität (C1a, C1b, C1c) der jeweiligen Kondensatordurchführung (2a, 2b, 2c) sowie von der Messspannung (U1b, U1c, U1a), einer Unterkapazität (C1b, C1c, C1a) und einer Oberkapazität (COb, C0c, C0a) einer der anderen Kondensatordurchführungen (2b, 2c, 2a) abhängt;
- Mittel, die derart ausgebildet sind, dass sie für jede Kondensatordurchführung (2a, 2b, 2c) die jeweilige Oberkapazität (C0a, C0b, C0c) mit der jeweiligen Istkapazität (COa', COb', COc') vergleichen;
- Mittel, die derart ausgebildet sind, dass sie ein Überwachungssignal erzeugen, dass von den Ergebnissen der Kapazitätsvergleiche abhängt.

12. Vorrichtung (1) nach Anspruch 11, zusätzlich aufweisend

- Mittel, die derart ausgebildet sind, dass sie die Netzspannungen (Ua, Ub, Uc) einer jeden Phase (Pa, Pb, Pc) erfassen;
- Mittel, die derart ausgebildet sind, dass sie die Netzspannungen (Ua, Ub, Uc) untereinander vergleichen;
- Mittel, die derart ausgebildet sind, dass sie, falls der Spannungsvergleich ergibt, dass die Netzspannungen

(Ua, Ub, Uc) nicht mehr als ein vorbestimmtes Maß (UAB, UBC, UCA) voneinander abweichen, dann das Berechnen der Istkapazitäten (COa', COb', COc'), das Vergleichen der Kapazitäten (COa, C0b, C0c, COa', COb', COc') und das Erzeugen des Überwachungssignals veranlassen oder ausführen.

13. Vorrichtung (1) nach Anspruch 11, die derart ausgebildet ist, dass sie eines der Verfahren gemäß einem der Ansprüche 1-10 ausführt.


**Claims**

1. Method for monitoring capacitor bushings (2a, 2b, 2c) for a three-phase alternating current mains, wherein each capacitor bushing (2a, 2b, 2c) comprises a conductor (4), which is connected with one of the mains lines (5a, 5b, 5c) of the alternating current mains, and an electrically conductive lining (3) surrounding the conductor (4), comprising the steps:

   - an upper capacitance (COa, C0b, C0c) and a lower capacitance (C1a, C1b, C1c) are determined for each capacitor bushing (2a, 2b, 2c);
   - a measured voltage (U1a, U1b, U1c) present between the respective lining (3) and a ground potential (13) is detected at each capacitor bushing (2a, 2b, 2c); **characterized in that**,
   - an actual capacitance (C0a', COb', COc') is calculated for each capacitor bushing (2a, 2b, 2c), the actual capacitance depending on the respective measured voltage (U1a, U1b, U1c) and the respective lower capacitance (C1a, C1b, C1c) as well as on the measured voltage (U1b, U1c, U1a), the lower capacitance (C1b, C1c, C1a) and the upper capacitance (COb, C0c, C0a) of one of the other capacitor bushings (2b, 2c, 2a);
   - for each capacitor bushing (2a, 2b, 2c) the respective upper capacitance (COa, C0b, C0c) is compared with the respective actual capacitance (C0a', C0b', C0c'); and
   - a monitoring signal dependent on the results of the capacitance comparison is generated.

2. Method according to claim 1, wherein

   - the mains voltage (Ua, Ub, Uc) is detected for each phase (Pa, Pb, Pc);
   - the mains voltages (Ua, Ub, Uc) are compared with one another; and
   - if the voltage comparison has the result that the mains voltages (Ua, Ub, Uc) differ from one another by not more than a predetermined amount (UAB, UBC, UCA) the calculation of the actual capacitances (COa', COb', COc'), the comparison of the capacitances (COa, C0b, C0c, COa', COb', COc') and the generation of the monitoring signal take place.

3. Method according to claim 2, wherein

   - effective values (Uae, Ube, Uce) and/or peak values and/or amplitudes of the mains voltages (Ua, Ub, Uc) are used in the voltage comparison.

4. Method according to claim 3, wherein

   - tolerance values UAB > 0, UBC > 0, UCA > 0 for the voltage comparison are determined; and
   - the voltage comparison is carried out in such a way that it is checked whether |Uae - Ube| ≤ UAB and |Ube - Uce| ≤ UBC and |Uce - Uae| ≤ UCA.

5. Method according to claim 1, wherein

   - the actual capacitance (COa') of the first capacitor bushing (2a) is calculated according to the following formula:

$$C_{0a}' = C_{1a} \times \frac{U_{1a} \times K_a}{\dfrac{U_{1b} \times C_{1b}}{C_{0b}} + U_{1b} - U_{1a} \times K_a}$$

wherein Ka is a correction value for which Ka = 1 or Ka = Ub/Ua; and/or

- the actual capacitance (COb') of the second capacitor bushing (2b) is calculated according to the following formula:

$$C_{0b}{}' = C_{1b} \times \dfrac{U_{1b} \times K_b}{\dfrac{U_{1c} \times C_{1c}}{C_{0c}} + U_{1c} - U_{1b} \times K_b}$$

wherein Kb is a correction value for which Kb = 1 or Kb = Uc/Ub; and/or
- the actual capacitance (C0c') of the third capacitor bushing (2c) is calculated according to the following formula:

$$C_{0c}{}' = C_{1c} \times \dfrac{U_{1c} \times K_c}{\dfrac{U_{1a} \times C_{1a}}{C_{0a}} + U_{1a} - U_{1c} \times K_c}$$

wherein Kc is a correction value for which Kc = 1 or Kc = Ua/Uc.

6. Method according to claim 5, wherein

- tolerance values CA > 0, CB > 0, CC > 0 for the capacitance comparisons are determined; and
- if the capacitance comparisons have the result that

|C0a' - C0a| ≤ CA and |C0b' - C0b| ≤ CB and |C0c' - C0c| ≤ CC

a monitoring signal is generated which indicates that the capacitor bushings (2a, 2b, 2c) are in an orderly state.

7. Method according to claim 6, wherein

- otherwise a monitoring signal is generated which indicates that at least one capacitor bushing is not in an orderly state.

8. Method according to claim 5, wherein

- tolerance values CA > 0, CB > 0, CC > 0 for the capacitance comparisons are determined;
- if the capacitance comparisons have the result that

C0a' - C0a < -CA and C0b' - C0b > CB and |C0c' - C0c| ≤ CC

a monitoring signal is generated which indicates that at least the second capacitor bushing (2b) is not in an orderly state;
- if the capacitance comparisons have the result that

C0b' - C0b < -CB and C0c' - C0c > CC and |C0a' - C0a| ≤ CA

a monitoring signal is generated which indicates that at least the third capacitor bushing (2c) is not in an orderly state; and
- if the capacitance comparisons have the result that

C0c' - C0c < -CC and C0a' - C0a > CA and |C0b' - C0b| ≤ CB

a monitoring signal is generated which indicates that at least the first capacitor bushing (2a) is not in an orderly state.

9. Method according to claim 8, wherein

- otherwise a monitoring signal is generated which indicates that at least two capacitor bushings are not in an orderly state.

10. Method according to claim 5, wherein

- tolerance values CA > 0, CB > 0, CC > 0 for the capacitance comparisons are determined;
if the capacitance comparisons have the result that

$$C0a' - C0a > CA \text{ and } C0b' - C0b < -CB \text{ and } |C0c' - C0c| \leq CC$$

a monitoring signal is generated which indicates that the first and third capacitor bushings (2a, 2c) are not in an orderly state and have an identical fault;
- if the capacitance comparisons have the result that

$$C0b' - C0b > CB \text{ and } C0c' - C0c < -CC \text{ and } |C0a' - C0a| \leq CA$$

a monitoring signal is generated which indicates that the second and first capacitor bushings (2b, 2a) are not in an orderly state and have an identical fault; and
- if the capacitance comparisons have the result that

$$C0c' - C0c > CC \text{ and } C0a' - C0a < -CA \text{ and } |C0b' - C0b| \leq CB$$

a monitoring signal is generated which indicates that the third and second capacitor bushings (2c, 2b) are not in an orderly state and have an identical fault.

11. Device (1) for monitoring capacitor bushings (2a, 2b, 2c) for a three-phase alternating current mains, wherein each capacitor bushing (2a, 2b, 2c) comprises a conductor (4), which is connected with the one of the mains lines (5a, 5b, 5c) of the alternating current mains, and an electrically conductive lining (3) surrounding the conductor (4), wherein the device is constructed particularly as a device for carrying out a method according to any one of the preceding claims and comprises

- means constructed to detect at each capacitor bushing (2a, 2b, 2c) a measurement voltage (U1a, U1b, U1c) present between the respective lining (3) and a ground potential (13);

**characterized by**,

- means constructed to calculate for each capacitor bushing (2a) an actual capacitance (COa', COb', COc') which depends on the respective measurement voltage (U1a, U1b, U1c) and a lower capacitance (C1a, C1b, C1c) of the respective capacitor bushing (2a, 2b, 2c) as well as on the measurement voltage (U1b, U1c, U1a), a lower capacitance (C1b, C1c, C1a) and an upper capacitance (COb, C0c, C0a) of one of the other capacitor bushings (2b, 2c, 2a);
- means constructed to compare the respective upper capacitance (COa, C0b, C0c) with the respective actual capacitance (COa', COb', COc') for each capacitor bushing (2a, 2b, 2c); and
- means constructed to produce a monitoring signal dependent on the results of the capacitance comparisons.

12. Device (1) according claim 11, additionally comprising

- means constructed to detect the mains voltages (Ua, Ub, Uc) of each phase (Pa, Pb, Pc);
- means constructed to compare the mains voltages (Ua, Ub, Uc) with one another; and

- means constructed to cause or carry out calculation of the actual capacitances (COa', COb', COc'), comparison of the capacitances (COa, C0b, C0c, COa', COb', COc') and generation of the monitoring signal if the voltage comparison has the result that the mains voltages (Ua, Ub, Uc) differ from one another by not more than a predetermined amount (UAB, UBC, UCA).

13. Device (1) according to any claim 11, which is constructed to carry out or be able to carry out one of the methods according to claims 1-10.

**Revendications**

1. Procédé de surveillance de condensateurs de traversée (2a, 2b, 2c) destinés à un réseau de courant alternatif triphasé, selon lequel chaque condensateur de traversée (2a, 2b, 2c) comporte un conducteur (4) qui est relié à l'un des conducteurs (5a, 5b, 5c) du réseau de courant alternatif ainsi qu'une armature électriquement conductrice (3) qui entoure le conducteur (4), comprenant des étapes selon lesquelles :

   - pour chaque condensateur de traversée (2a, 2b, 2c) on détermine une capacité haute (COa, C0b, C0c) et une capacité basse (C1a, C1b, C1c),
   - sur chaque condensateur de traversée (2a, 2b, 2c) on évalue une tension de mesure (U1a, U1b, U1c) qui est appliquée entre l'armature (3) respective et un potentiel de masse (13),

   **caractérisé en ce que**

   - pour chaque condensateur de traversée (2a, 2b, 2c) on calcule une capacité réelle (COa', COb', COc') qui dépend de la tension de mesure respective (U1a, U1b, U1c), de la capacité basse respective (C1a, C1b, C1c) ainsi que de la tension de mesure (U1b, U1c, U1a) de la capacité basse (C1b, C1c, C1a) et de la capacité haute (COb, C0c, C0a) de l'un des autres condensateurs de traversée (2b, 2c, 2a),
   - pour chaque condensateur de traversée (2a, 2b, 2c) on compare la capacité haute respective (COa, C0b, C0c) avec la capacité réelle respective (COa', COb', COc'),
   - on produit un signal de surveillance qui dépend des résultats de la comparaison de capacité.

2. Procédé conforme à la revendication 1, selon lequel :

   - pour chaque phase (Pa, Pb, Pc) on évalue la tension de réseau (Ua, Ub, Uc),
   - on compare les tensions de réseau (Ua, Ub, Uc) les unes aux autres,
   - lorsque la comparaison de tension indique que les tensions de réseau (Ua, Ub, Uc) ne s'écartent pas les unes des autres de plus d'une valeur prédéfinie (UAB, UBC, UCA), on effectue le calcul des capacités réelles (C0a', C0b', C0c'), la comparaison des capacités (COa, C0b, C0c, COa', COb', COc') et la production du signal de surveillance.

3. Procédé conforme à la revendication 2,
   selon lequel lors de la comparaison des tensions on utilise des valeurs efficaces (Uae, Ube, Uce) et/ou des valeurs de crête et/ou les amplitudes des tensions de réseau (Ua, Ub, Uc).

4. Procédé conforme à la revendication 3,
   selon lequel

   - on détermine des valeurs de tolérance (UAB>0, UBC>0, UCA>0) pour la comparaison des tensions,
   - on effectue la comparaison des tensions en vérifiant les conditions : |Uae-Ube|≤UAB et |Ube-Uce|≤UBC et |Uce-Uae|≤UCA sont satisfaites.

5. Procédé conforme à la revendication 1,
   selon lequel

   - on calcule la capacité réelle (COa') du premier condensateur de traversée (2a) conformément à la formule ci-dessous :

$$C_{0a}' = C_{1a} \times \frac{U_{1a} \times K_a}{\dfrac{U_{1b} \times C_{1b}}{C_{0b}} + U_{1b} - U_{1a} \times K_a}$$

dans laquelle Ka représente une valeur de correction selon laquelle Ka= 1 ou Ka = Ub/Ua, et/ou

- on calcule la capacité réelle (COb') du second condensateur de traversée (2b) conformément à la formule ci-dessous :

$$C_{0b}' = C_{1b} \times \frac{U_{1b} \times K_b}{\dfrac{U_{1c} \times C_{1c}}{C_{0c}} + U_{1c} - U_{1b} \times K_b}$$

dans laquelle Kb représente une valeur de correction selon laquelle Kb= 1 ou Kb = Uc/Ub, et/ou

- on calcule la capacité réelle (C0c') du troisième condensateur de traversée (2c) conformément à la formule ci-dessous :

$$C_{0c}' = C_{1c} \times \frac{U_{1c} \times Kc}{\dfrac{U_{1a} \times C_{1a}}{C_{0a}} + U_{1a} - U_{1c} \times Kc}$$

dans laquelle Kc représente une valeur de correction selon laquelle Kc=1 ou Kc=Ua/Uc.

6. Procédé conforme à la revendication 5, selon lequel

- on détermine des valeurs de tolérance CA>0, CB>0, CC>0 pour la comparaison des capacités,
- dans le cas où les comparaisons des capacité indiquent que les conditions :

$$|C0a'\text{-}C0a| \leq CA \text{ et } |C0b'\text{-}C0b| \leq CB \text{ et } |C0c'\text{-}C0c| \leq CC$$

sont satisfaites, on produit un signal de correction qui indique que les condensateurs de traversée (2a, 2b, 2c) sont dans un état correct.

7. Procédé conforme à la revendication 6, selon lequel :
dans le cas contraire on produit un signal de surveillance qui indique qu'au moins un condensateur de traversée n'est pas dans un état correct.

8. Procédé conforme à la revendication 5, selon lequel :

- on détermine des valeurs de tolérance CA >0, CB > 0, CC>0 pour les comparaisons des capacités,
- si les comparaisons des capacités indiquent que les conditions :

$$C0a'\text{-}C0a < \text{-}CA \text{ et } C0b'\text{-}C0b > CB \text{ et } |C0c'\text{-}C0c| \leq CC$$

sont satisfaites, on produit un signal de surveillance qui indique qu'au moins le second condensateur de traversée (2b) n'est pas dans un état correct,
- si les comparaisons de capacité indiquent que les conditions :

$$C0b'-C0b<-CB \text{ et } C0c'-C0c >CC \text{ et } \left|V0a'-C0a\right|\leq CA$$

sont satisfaites, on produit un signal de surveillance qui indique qu'au moins le troisième condensateur de traversée (2c) n'est pas dans un état correct,
- si les comparaisons de capacité indiquent que les conditions :

$$C0c'-C0c <-CC \text{ et } C0a'-C0a >CA \text{ et } \left|C0b'-C0b\right|\leq CB$$

sont satisfaites, on produit un signal de surveillance qui indique qu'au moins le premier condensateur de traversée (2a) n'est pas dans un état correct.

9. Procédé conforme à la revendication 8, selon lequel sinon on produit un signal de surveillance qui indique qu'au moins deux condensateurs de traversée ne sont pas dans un état correct.

10. Procédé conforme à la revendication 5, selon lequel

- on détermine des valeurs de tolérance CA>0, CB>0, CC>0 pour les comparaisons des capacités,
si les comparaisons des capacités indiquent que les conditions :

$$C0a'-C0a>CA \text{ et } C0b'-C0b<-CB \text{ et }\left|C0c'-C0c\right|\leq CC$$

sont satisfaites, alors on produit un signal de surveillance qui indique que le premier condensateur de traversée et le second condensateur de traversée (2a, 2c) ne sont pas dans un état correct et ont un défaut similaire,
- si les comparaisons des capacités indiquent que les conditions :

$$C0b'-C0b>CB \text{ et } C0c'-C0c<-CC \text{ et }\left|C0a'-C0a\right|\leq CA$$

sont satisfaites, on produit un signal de surveillance qui indique que le second condensateur de traversée et le premier condensateur de traversée (2b, 2a) ne sont pas dans un état correct et ont un défaut similaire,
- si les comparaisons de capacité indiquent que les conditions :

$$C0c'-C0c>CC \text{ et } C0a'-C0a<-CA \text{ et } \left|C0b'-C0b\right|\leq CB$$

sont satisfaites, on produit un signal de surveillance qui indique que le troisième condensateur de traversée et le second condensateur de traversée (2c, 2b) ne sont pas dans un état correct et ont un défaut similaire.

11. Procédé (1) de surveillance de condensateur de traversée (2a, 2b, 2c) destinés à un réseau de courant alternatif triphasé, selon lequel

- chaque condensateur de traversée (2a, 2b, 2c) comporte un conducteur (4) qui est relié à l'un des conducteurs (5a, 5b, 5c) du réseau de courant alternatif et comporte une armature électriquement conductrice (3) qui entoure le conducteur (4), comprenant :
- des moyens qui sont réalisés de façon à évaluer sur chaque condensateur de traversée (2a, 2b, 2c) une tension de mesure (U1a, U1b, U1c) qui est appliquée entre l'armature (3) respective et le potentiel de masse (13),

**caractérisé en ce qu'**il comporte :

- des moyens qui sont réalisés de façon à calculer pour chaque condensateur de traversée (2a) une capacité réelle (C0a', C0b', C0c') qui dépend de la tension de mesure respective (U1a, U1b, U1c), d'une capacité basse (C1a, C1b, C1c) de chaque condensateur de traversée (2a, 2b, 2c) ainsi que de la tension de mesure (U1b, U1c, U1a), d'une capacité basse (C1b, C1c, C1a) ou d'une capacité haute (C0b, C0c, C0a) de l'un des autres condensateurs de traversée (2b, 2c, 2a),

- des moyens qui sont réalisés de façon à comparer pour chaque condensateur de traversée (2a, 2b, 2c) la capacité haute respective (COa, C0b, C0c) avec la capacité réelle respective (C0a', C0b', C0c'),
- des moyens qui sont réalisés de façon à produire un signal de surveillance qui dépend des résultats de la comparaison des capacités.

12. Dispositif (1) conforme à la revendication 11,
comprenant en outre :

- des moyens qui sont réalisés de façon à évaluer les tensions de réseau (Ua, Ub, Uc) d'une phase respective (Pa, Pb, Pc),
- des moyens qui sont réalisés pour comparer entre elles les tensions de réseau (Ua, Ub, Uc),
- des moyens qui sont réalisés de sorte que, si la comparaison des tensions indique que les tensions de réseau (Ua, Ub, Uc) ne diffèrent pas les unes des autres de plus d'une valeur prédéterminée (UAB, UBC, UCA), ils autorisent ou effectuent le calcul des capacités réelles (COa', COb', COc') la comparaison des capacités (COa, C0b, C0c, COa', COb', COc') et la production du signal de surveillance.

13. Dispositif (1) conforme à la revendication 11, réalisé de façon à mettre en œuvre un procédé conforme à l'une des revendications 1 à 10.

FIG. 1

# FIG. 2

EP 3 069 359 B1

**FIG. 3**

**FIG. 4**

**EP 3 069 359 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19519230 C1
- DE 10037432 A1
- DE 3601934 C2
- US 4757263 A